# EUROPÄISCHE PATENTSCHRIFT

(11) **EP 3 596 750 B1**
(45) Veröffentlichungstag und Bekanntmachung des Hinweises auf die Patenterteilung: **17.01.2024**
(21) Anmeldenummer: 17713196.8
(22) Anmeldetag: 16.03.2017
(51) Int. Cl.: H01L 21/67, H01L 21/68

(54) **VERFAHREN ZUM BONDEN VON MINDESTENS DREI SUBSTRATEN**
METHOD FOR BONDING AT LEAST THREE SUBSTRATES
PROCÉDÉ D'ASSEMBLAGE D'AU MOINS TROIS SUBSTRATS

(43) Veröffentlichungstag der Anmeldung: 22.01.2020
(73) Patentinhaber: EV Group E. Thallner GmbH, St. Florian am Inn (AT)
(72) Erfinder: GLINSNER, Thomas, 4782 St. Florian am Inn (AT); WAGENLEITNER, Thomas, 4971 Aurolzmünster (AT); ZAGLMAYR, Harald, 4080 Vöcklabruck (AT)
(74) Vertreter: Schneider, Sascha
(86) Internationale Anmeldenummer: PCT/EP2017/056301
(87) Internationale Veröffentlichungsnummer: WO 2018/166605

(56) Entgegenhaltungen:
- WO-A1-2011/019881
- US-A1- 2012 031 557
- US-A1- 2012 152 433
- US-A1- 2015 044 786
- US-A1- 2016 148 826

## Beschreibung

In der Mikrooptik werden seit einigen Jahren Anstrengungen unternommen, mehrere optische Elemente im Millimeter- oder Mikrometermaßstab übereinander zu stapeln. Durch die Stapelung mehrere unterschiedlicher optischer Elemente wird es möglich, hochkomplizierte optische Systeme im Millimeter- bzw. Mikrometermaßstab aufzubauen. Dadurch können diese hochkomplizierten optischen Systeme in Smartphones, Tablets und anderen elektronischen Geräten untergebracht werden. Durch die stetig voranschreitende Miniaturisierung müssen auch die optischen Systeme entsprechend kleiner werden. Um der immer schneller voranschreitenden Miniaturisierung gerecht zu werden, müssen Prozesse geschaffen werden, die einerseits die Massenproduktion derartiger Produkte erlauben, andererseits aber auch die Präzision, mit der die einzelnen optischen Elemente zueinander ausgerichtet werden, verbessern. US 201203 1557A1 offenbart ein Verfahren zum Bonden mit mehreren Schichten. US 2012152433A1 offenbart ein Verfahren zum Bonden von Substraten, wobei eine Temperatur einer Klebemasse kontrolliert wird. WO2011019881 A1 offenbart ein Verfahren zum Bonden von Wafern mit Mikrowellenenergie.

Im Stand der Technik werden die optischen Elemente auf einem Substrat, insbesondere einem Wafer, hergestellt. Auf einem Wafer befinden sich mehrere hundert bis tausend derartiger optischer Elemente. Die optischen Elemente wurden mit extrem hoher Präzision auf dem Substrat gefertigt. Um ein hochkomplexes optisches System aus mehreren, insbesondere unterschiedlichen, übereinander gestapelten, optischen Elementen zu erhalten, werden mehrere derartige Substrate mit, im Allgemeinen unterschiedlichen, optischen Elementen, miteinander verbunden. Diesen Verbindungsvorgang nennt man Bonden. Vor dem Verbinden ist es unabdingbar, dass die beiden miteinander zu verbindenden Substrate mit sehr hoher Präzision zueinander ausgerichtet werden müssen. Diese erzielte hohe Ausrichtungsgenauigkeit muss auch während der Annäherung der beiden Substrate aneinander aufrechterhalten werden.

Das größte Problem im Stand der Technik besteht darin, dass Substratstapel mit heutigen Methoden so aufgebaut werden, dass das n+1 Substrat immer zum n-ten Substrat ausgerichtet wird. Durch den Bezug des n+1-ten Substrats zum n-ten Substrat kommt es über den Substratstapel hinweg zu einer Fehlerfortpflanzung der Ausrichtung. Das soll an folgendem Beispiel erläutert werden: Wurde das zweite Substrat relativ zum ersten Substrat mit einem, wenn auch geringen, Fehler ausgerichtet und verbondet, so wird der Fehler des dritten Substrats zum ersten Substrat im Allgemeinen noch größer sein. Man kann sich bei einer derartigen Stapelfolge auch nicht darauf verlassen, dass sich die Fehler mit zunehmender Substratanzahl im Stapel statistisch aufheben, da dazu die Anzahl der Substrate im Stapel zu gering ist. Des Weiteren hat jeder Fehler in der Ausrichtung zwischen zwei Substraten eine direkte Auswirkung auf den optischen Pfad des gesamten, hochkomplexen optischen Systems. Durchläuft in der späteren Anwendung eine Lichtfront das hochkomplexe optische System, so kann ein entsprechender Fehler in der Positionierung zweier optischer Elemente eine Lichtfront unwiderruflich stören und damit die gesamte optische Abbildung beeinträchtigen.

Es ist die Aufgabe der vorliegenden Erfindung, ein Verfahren und einen Substrathalter zur Verfügung zu stellen, mit denen die Nachteile des Standes der Technik beseitigt und die Ausrichtungsfehler beim Bonden der Substrate minimiert werden können und hochkomplexe optische Systeme mit geringen Abweichungen hergestellt werden können.

Diese Aufgabe wird mit dem Gegenstand der nebengeordneten Patentansprüche gelöst.

Vorteilhafte Weiterbildungen der Erfindung sind in den Unteransprüchen angegeben. In den Rahmen der Erfindung fallen auch sämtliche Kombinationen aus zumindest zwei in der Beschreibung, in den Ansprüchen und/oder den Zeichnungen angegebenen Merkmalen. Bei angegebenen Wertebereichen sollen auch innerhalb der genannten Grenzen liegende Werte als Grenzwerte offenbart gelten und in beliebiger Kombination beanspruchbar sein. Soweit einzelne oder mehrere Verfahrensschritte auf unterschiedlichen Geräten oder Modulen ausführbar sind, werden diese als eigenständiges Verfahren jeweils separat offenbart.

Im Folgenden beziehen sich die Richtungen X und Y auf zueinander senkrechte Richtungen in der Substratebene. Die Z-Richtung ist senkrecht zur Substratebene beziehungsweise zu den Richtungen X und Y angeordnet, sodass sich ein kartesisches Koordinatensystem ergibt.

Im weiteren Verlauf der Druckschrift wird die erfindungsgemäße Methode exemplarisch an der Ausrichtung von Substraten mit optischen Elementen, insbesondere Linsen, erläutert. Dem Fachmann auf dem Gebiet ist klar, dass das erfindungsgemäße Verfahren nicht auf die Ausrichtung von Substraten mit optischen Elementen eingeschränkt ist, sondern sich zur Ausrichtung beliebiger Substrate in einem Substratstapel eignet und anwenden lässt. Insbesondere kann das Verfahren beispielsweise noch zur Ausrichtung mehrere Substrate mit TSVs (engl.: though-silicon-vias) verwendet werden. Vor allem Substratstapel mit TSV Verbindungen zwischen den Substraten werden auf Grund der voranschreitenden 3D Technologie elektronischer Bauteile, immer wichtiger. Derartige TSV Substrate sind vor allem zur Herstellung von Speichern von fundamentaler Bedeutung.

Erfindungsgemäß vorgesehen ist ein Verfahren zum Bonden von mindestens drei Substraten mit optischen Linsen zu einem Substratstapel, so dass die Linsen übereinander angeordnet werden, wobei der Substratstapel mindestens ein unterstes Substrat, ein mittleres Substrat und ein oberes Substrat aufweist, mit den folgenden Schritten:
- Ausrichtung des mittleren Substrats zum untersten Substrat und Bonden des mittleren Substrats mit dem untersten Substrat ,
- danach Ausrichtung des oberen Substrats und Bonden des oberen Substrats mit dem mittleren Substrat, dadurch gekennzeichnet, dass das obere Substrat zum untersten Substrat ausgerichtet wird.

In einer bevorzugten Ausführungsform ist es vorgesehen, dass optische Achsen der übereinander angeordneten Linsen annähernd deckungsgleich ausgerichtet sind. Insbesondere beträgt der Abstand zwischen den optischen Achsen weniger als 1 µm, bevorzugt weniger als 500 nm, noch bevorzugter weniger als 50 nm, am bevorzugtesten weniger als 10 nm, am allerbevorzugtesten weniger als 5 nm. Dadurch ist vorteilhaft erreichbar, dass eine optimale Anordnung der optischen Elemente möglich ist. Im Folgenden wird deckungsgleich auch mit kollinear bezeichnet. Die Kollinearität ist dabei nicht mathematisch streng auszulegen. In der Realität wird man eine vollständige Kollinearität nie erreichen. Insbesondere ist unter Kollinearität zu verstehen, dass der Winkel zwischen den optischen Achsen kleiner ist als 5°, vorzugsweise kleiner ist als 1.0°, noch bevorzugter kleiner ist als 0.5°, am bevorzugtesten kleiner ist als 0.1°, am allerbevorzugtesten kleiner ist als 0.05°.

Gemäß einer anderen bevorzugten Ausführungsform ist es vorgesehen, dass das obere Substrat zu Ausrichtungsmarken des untersten Substrats ausgerichtet wird. Die Ausrichtungsmarken können auf der Ober- und/oder Unterseite des untersten Substrats angeordnet sein.

Gemäß einer anderen bevorzugten Ausführungsform ist es vorgesehen, dass jedes nachfolgende Substrat zum untersten Substrat ausgerichtet wird. Dadurch ist es vorteilhaft möglich, den Ausrichtungsfehler bei den nachfolgenden Substraten weitgehend zu minimieren.

Gemäß einer anderen bevorzugten Ausführungsform ist es vorgesehen, dass jedes Substrat eine Vielzahl an optischen Linsen aufweist. Dadurch ist es vorteilhaft möglich eine Vielzahl an übereinander gestapelten Linsen erzeugen zu können.

Gemäß einer anderen bevorzugten Ausführungsform ist es vorgesehen, dass jedes Substrat eine Vielzahl an TSVs aufweist. Dadurch ist es vorteilhaft möglich eine Vielzahl an übereinander gestapelten Substraten, deren funktionale Einheiten über TSVs miteinander verbunden sind, erzeugen zu können.

Gemäß einer anderen bevorzugten Ausführungsform ist es vorgesehen, dass mindestens drei Substrate miteinander gebondet werden, bevorzugt mindestens fünf Substrate, weiter bevorzugt mindestens 10 Substrate, noch weiter bevorzugt mindestens 15 Substrate. Dadurch sind vorteilhaft komplexe optische Systeme herstellbar.

Gemäß einer anderen bevorzugten Ausführungsform weist das erfindungsgemäße Verfahren, den folgenden Ablauf auf:
- Anordnen und Fixieren des untersten Substrats auf einem unteren Substrathalter,
- Erfassen von Ausrichtungsmarken auf dem untersten Substrat in Sichtbereichen von Optiken,
- Anordnen und Fixieren des mittleren Substrats auf einem oberen Substrathalter,
- Erfassung von Ausrichtungsmarken auf dem mittleren Substrat mittels der Optiken,
- Ausrichten des mittleren Substrats zum untersten Substrat,
- Bonden des mittleren Substrats mit dem untersten Substrat, wobei die gebondeten Substrate auf dem unteren Substrathalter verbleiben,
- Anordnen und Fixieren des oberen Substrats auf dem oberen Substrathalter,
- Erfassung von Ausrichtungsmarken auf dem oberen Substrat mittels der Optiken,
- Ausrichten des oberen Substrats zum untersten Substrat,
- Bonden des oberen Substrats mit dem mittleren Substrat zur Herstellung des Substratstapels.

Gemäß einer anderen bevorzugten Ausführungsform ist es vorgesehen, dass die Erfassung der Ausrichtungsmarken durch unter dem untersten Substrat angeordnete Optiken durch Ausnehmungen im unteren Substrathalter erfolgt. Es kann notwendig sein, den Substrathalter über die Optiken zu heben, sodass die Optiken in den Ausnehmungen positioniert werden.

Gemäß einer anderen bevorzugten Ausführungsform ist es vorgesehen, dass die Ausnehmungen als durchgängige Bohrungen im unteren Substrathalter ausgebildet sind. In den durchgängigen Bohrungen können die Optiken vorteilhaft besonders effizient angeordnet werden.

Gemäß einer anderen bevorzugten Ausführungsform ist vorgesehen, dass die Ausnehmungen als Langlöcher im unteren Substrathalter ausgebildet sind. In den Langlöchern kann der untere Substrathalter vorteilhaft besonders effizient über die unteren Optiken bewegt werden.

Gemäß einer anderen bevorzugten Ausführungsform ist vorgesehen, dass der untere Substrathalter derart verfahrbar ist, dass die unteren Optiken innerhalb von Ausnehmungen angeordnet sind.

Gemäß einer anderen bevorzugten Ausführungsform ist vorgesehen, dass der untere Substrathalter durch eine Z-Positioniereinheit derart präzise in Z-Richtung verfahren wird, dass eine Abweichung in einer X- und Y-Richtung minimal ist. Dadurch kann der untere Substrathalter vorteilhaft höchst präzise zum Bonden verfahren werden.

Gemäß einer anderen bevorzugten Ausführungsform ist vorgesehen, dass eine Nachjustiereinheit eine Abweichung des unteren Substrathalters in X- und/oder Y-Richtung bei einer Bewegung in Z-Richtung korrigiert. Dadurch kann der untere Substrathalter vorteilhaft höchst präzise zum Bonden verfahren werden.

Gemäß einer anderen Ausführungsform ist vorgesehen, dass der untere Substrathalter gänzlich aus dem Prozessbereich verfahren wird, um zu einem späteren Prozessschritt wieder in seine Ausgangsposition gebracht zu werden. In diesem Fall kann insbesondere ein Überheben des Substrathalters über die Optiken notwendig sein. Der untere Probenhalter wird dann vor dem Bondschritt wieder in seine Position verfahren. Dazu ist eine sehr genaue Positionierung in x-, y- und z-Richtung von Nöten.

Ein anderer Gegenstand der vorliegenden Erfindung betrifft einen Substrathalter, wobei der Substrathalter Ausnehmungen zur Aufnahme von Optiken und Fixierelemente, vorzugsweise Vakuumöffnungen, zur Fixierung eines Substrats aufweist.

Der Grundgedanke und Kern der Erfindung besteht darin, das neu hinzukommende Substrat zu den Ausrichtungsmarken des untersten Substrats auszurichten. Dabei ist es insbesondere von Bedeutung, dass die Motoren für die Bewegung in z-Richtung des Substrathalters, auf dem der Substratstapel aufgebaut wird, hochpräzise arbeiten.

Der Vorteil der Erfindung besteht darin, dass ein Substratstapel, und damit mehrere hochkomplexe, optische Systeme, mit einem minimalen Fehler zueinander ausgerichtet und gebondet werden können. Dadurch wird der Ausschuss reduziert und die bildgebenden Eigenschaften der einzelnen hochkomplexen optischen Systeme entscheidend verbessert.

Die z-Positioniereinheit darf nur ein vernachlässigbares Spiel in der x- und/oder y-Richtung besitzen oder man muss ein Korrektursystem verwenden, das sicherstellt, dass der Substrathalter, der sich in z-Richtung bewegt, nachjustiert wird. Bei dem Korrektursystem kann es sich insbesondere um eine Regelschleife zwischen den X- und Y-Motoren einerseits und Detektoren andererseits handeln. Die Detektoren vermessen während der z-Positionierung kontinuierlich die X- und/oder Y-Position des Substrathalters und leiten entsprechende Veränderungen an Verstellelemente, insbesondere Motoren, noch bevorzugter Piezoelemente, weiter, welche die Nachjustierung vornehmen. Insbesondere handelt es sich bei den Detektoren um Optiken, welche Ausrichtungsmarken an der Unterseite des Substrathalters vermessen oder um Laserinterferometer, welche die relative Positionsänderung der Seitenwände des Substrathalters vermessen. Derartige optische Messsysteme sind dem Fachmann bestens vertraut.

### Substrathalter

Der Substrathalter verfügt über Fixierungen. Die Fixierungen dienen dem Festhalten der Substrate. Bei den Fixierungen kann es sich handeln um:
1. Mechanische Fixierungen, insbesondere
   a. Klemmen
2. Vakuumfixierungen, insbesondere mit
   a. einzeln ansteuerbare Vakuumbahnen
   b. miteinander verbundenen Vakuumbahnen
3. Elektrische Fixierungen, insbesondere
   a. Elektrostatische Fixierungen
4. Magnetische Fixierungen
5. Adhäsive Fixierungen, insbesondere
   a. Gel-Pak Fixierungen
   b. Fixierungen mit adhäsiven, insbesondere ansteuerbaren, Oberflächen

Die Fixierungen sind insbesondere elektronisch ansteuerbar. Die Vakuumfixierung ist die bevorzugte Fixierungsart. Die Vakuumfixierung besteht vorzugsweise aus mehreren Vakuumbahnen, die an der Oberfläche des Substrathalters austreten. Die Vakuumbahnen sind vorzugsweise einzeln ansteuerbar. In einer technisch eher realisierbaren Anwendung sind einige Vakuumbahnen zu Vakuumbahnsegmenten vereint, die einzeln ansteuerbar, daher evakuiert oder geflutet werden können. Jedes Vakuumsegment ist allerdings unabhängig von den anderen Vakuumsegmenten. Damit erhält man die Möglichkeit des Aufbaus einzeln ansteuerbarer Vakuumsegmente. Die Vakuumsegmente sind vorzugsweise ringförmig konstruiert. Dadurch wird eine gezielte, radialsymmetrische, insbesondere von Innen nach Außen durchgeführte Fixierung und/oder Loslösung eines Substrats vom Substrathalter ermöglicht.

In einer beispielhaften erfindungsgemäßen Ausführungsform des Substrathalters sind die Ausnehmungen vollumfänglich geschlossene Bohrungen.

In einer anderen erfindungsgemäßen Ausführungsform des Substrathalters sind die Ausnehmungen zu einem Rand des Substrathalters hin offen und werden insbesondere durch einen einfachen Fräsvorgang hergestellt.

Der Substrathalter kann neben den Fixiermitteln auch Mittel zur aktiven mechanischen Beeinflussung, insbesondere Dehnung, noch bevorzugter lokalen Dehnung, der Substrate besitzen. Durch derartige Mittel wird vorzugsweise eine lokale Beeinflussung der horizontalen und/oder vertikalen Dehnung des Substrats ermöglicht, sodass lokale Dehnungen und/oder Spannungen verändert, insbesondere minimiert, werden können. Derartige Mittel wurden ausführlich in der Druckschrift WO2012083978A1 offenbart.

Als Substrathalter können beispielsweise, aber nicht ausschließend, die Substrathalter aus den Druckschriften WO2012083978A1, PCT/EP2016/056249, WO2013023708A1, WO2014191033A1, WO2015113641A1, WO2012079597A1 verwendet werden.

### Anlagen

In einer erfindungsgemäßen Ausführungsform besteht eine Ausrichtungsanlage aus mindestens einem unteren Substrathalter, einem oberen Substrathalter, zwei Erfassungseinheiten mit jeweils zwei Optiken, und vorzugsweise einer Positionsfehlerkorrekturvorrichtung (engl.: position error correction, PEC). Die Genauigkeit, mit der die Positionserfassung der Probenhalter mit der Positionsfehlerkorrekturvorrichtung durchgeführt wird, ist besser als 1 µm, vorzugsweise besser als 500 nm, noch bevorzugter besser als 100 nm, am bevorzugtesten besser als 50 nm, am allerbevorzugtesten besser als 10 nm. Die Positionsfehlerkorrekturvorrichtung ist vor allem von Bedeutung, wenn einer der beiden Substrathalter, insbesondere der untere Substrathalter, den Prozessberiech vollständig verlässt und in einem weiteren Prozessschritt wieder in den Prozessbereich verfahren werden muss. Die Verwendung einer Positionsfehlerkorrekturvorrichtung gewährleistet eine hochgenaue, erneute Positionierung des Substrathalters ohne eine erneute Vermessung der Ausrichtungsmarken.

Der untere Substrathalter besitzt insbesondere Ausnehmungen, durch welche die unteren Optiken an das Bondinterface bzw. untere Ausrichtungsmarken an der Unterseite des untersten Substrats herangeführt werden können. Der untere Substrathalter kann vorzugsweise in x- und/oder y- und/oder z-Richtung verschoben werden. In der weiteren Druckschrift und vor allem in den Figuren werden vor allem Ausführungsformen beschrieben und gezeigt, bei denen ein Substrathalter, insbesondere der untere Substrathalter, nach einer ersten Positionierung in der x- und y-Richtung, ausschließlich in z-Richtung verfahren wird. Denkbar ist aber auch, dass der Substrathalter den Prozessberiech vollständig verlässt, um zu einem späteren Zeitpunkt wieder in den Prozessbereich zu verfahren. Insbesondere kann bei jedem neuen Eintritt des Substrathalters in den Prozessbereich eine erneute Kalibrierung des Substrats auf dem Substrathalter durch die Optiken vorgenommen werden. Vorzugsweise wird der Substrathalter allerdings ausschließlich durch eine Positionsfehlerkorrekturvorrichtung in seine angestammte Position gebracht. Bei einem Substrathalter, der den gesamten Prozessbereich verlassen muss, kann es notwendig sein, dass man den Substrathalter über die Optiken, die in seinen Ausnehmungen versenkt wurden, überheben muss.

Der obere Substrathalter besitzt insbesondere Ausnehmungen, durch welche die oberen Optiken an das Bondinterface bzw. obere Ausrichtungsmarken auf der Oberseite des oberen Substrats herangeführt werden können. Vorzugsweise wird der obere Substrathalter aber so konstruiert, dass er über keine Ausnehmungen verfügt.

Der obere Substrathalter kann vorzugsweise in x- und/oder y- und/oder z-Richtung verschoben werden. Vorzugsweise kann der obere Substrathalter aber nur in eine Richtung verschoben werden, sodass auf Motoren für die weiteren beiden Richtungen verzichtet werden kann. Dadurch wird insbesondere eine hochgenaue Führung des oberen Substrathalters in eine Richtung ermöglicht.

Derartige Ausrichtungsanlagen werden ausführlich in den Druckschriften US6214692B1, WO2014202106A1 und WO2015082020A1 beschrieben.

### Prozesse

Mit Außenseite werden im weiteren Verlauf der Druckschrift alle Oberflächen bezeichnet, die in Richtung der Optiken zeigen. Mit Innenseiten werden im weiteren Verlauf der Druckschrift alle Oberflächen bezeichnet, die in Richtung des Bondinterfaces zeigen.

In allen folgenden Prozessen werden exemplarisch Ausführungsformen beschrieben und dargestellt, bei denen der untere Substrathalter relativ zum oberen Substrathalter, nach einer anfänglichen Positionierung in x- und/oder y-Richtung, ausschließlich eine Relativbewegung in z-Richtung durchführt. Anstatt dieser bevorzugten Verfahrensweise kann der Substrathalter auch vollständig aus dem Prozessbereich verfahren und wieder hochpräzise in den Prozessbereich zurückgebracht werden. Insbesondere wird eine erneute Kalibrierung des ersten Substrats des Substratstapels auf dem Substrathalter als Möglichkeit offenbart, um die korrekte Justierung des Substratstapels zum nächsten zu bondenden Substrat zu gewährleisten. Dabei ist, im Allgemeinen, nach jeder x- und/oder y-Bewegung des unteren Substrats bzw. Substratstapels durch eine Bewegung des unteren Substrathalters eine erneute Positionierung der Ausrichtungsmarken des ersten Substrats auf die optischen Achsen durchzuführen. Dies erfolgt vor allem dann sehr einfach, wenn sich die Ausrichtungsmarken des ersten Substrats an der Unterseite, und so direkt zugänglich für die Optiken befinden. Sind die Ausrichtungsmarken des ersten Substrats durch weitere Substrate bedeckt, da der Stapel bereits aufgebaut wurde, müssen die das erste Substrat oder die auf dem ersten Substrat gestapelten weiteren Substrat transparent in dem Wellenlängenbereich sein, in dem die Detektoren und Optiken arbeiten. Derartige Kalibrierungen sind vor allem dann notwendig, wenn der Substratstapel zwischen unterschiedlichen Räumen, Maschinen, Firmen und sogar Ländern verschifft werden muss.

Der Grundgedanke aller erfindungsgemäßen Prozesse besteht darin, mehrere übereinander gestapelte Substrate in Bezug zu den Ausrichtungsmarken eines ersten, bevorzugt untersten, Substrats zu kalibrieren. Das n+1 Substrat wird daher immer zum ersten Substrat, nicht zum n-ten Substrat kalibriert.

### Kalibrierprozess

Vor dem eigentlichen Ausrichtungsvorgang ist erfindungsgemäß eine Kalibrierung der Erfassungseinheiten von Vorteil. Das Ziel der Kalibrierung besteht insbesondere darin, den Schnittpunkt der optischen Achsen zweier, jeweils gegenüberliegender Erfassungsgeräte in das Zentrum einer Ausrichtungsmarkierung eines Kalibrierungssubstrats zu legen. Diese Kalibrierung erfolgt vorzugsweise getrennt für alle Optiken der Erfassungseinheiten. Durch die Kalibrierung wird sichergestellt, dass gegenüberliegende (obere und untere) Optiken einer Erfassungseinheit einen gemeinsamen Fokusbereich, d.h. gemeinsame oder zumindest größtenteils überlagernde Schärfentiefebereiche und gemeinsame oder zumindest größtenteils überlagernde Sichtbereiche, aufweisen. Im weiteren Verlauf der Druckschrift wird daher unter Fokussierung immer verstanden, dass die korrekten Schärfentiefebereiche und/oder Sichtbereiche vorhanden sind, um das zu fokussierende Objekt, insbesondere eine Ausrichtungsmarke, bestmöglich abzubilden.

In einer bevorzugten Ausführungsform sind die optischen Achsen der beiden gegenüberliegenden Optiken kollinear (deckungsgleich) zueinander. Hierzu weisen die Optiken insbesondere Rotationsfreiheitsgrade auf, vorzugweise durch Anordnung auf einem Goniometer.

Ein oder der Schnittpunkt der optischen Achsen der Optiken wird erfindungsgemäß insbesondere so angeordnet, dass die korrespondierenden Ausrichtungsmarkierungen der auszurichtenden Substrate in einer Erfassungsposition in X-, Y- und Z-Richtung in diesem Punkt zumindest fokussierbar und/oder anordenbar bzw. angeordnet sind. Im Allgemeinen können sich die Positionen der Ausrichtungsmarkierungen von Substratpaar zu Substratpaar ändern. Durch diese Maßnahme werden Verfahrwege erfindungsgemäß weiter minimiert. Der Allgemeinheit wegen wird folgender Umstand erwähnt. Der technisch kaum zu realisierende Fall, dass sich zwei optische Achsen kollinear, also deckungsgleich, zueinander sind würde bedeuten, dass es unendlich viele Schnittpunkte gibt und dass man die z-Position, an welcher die Vermessung der Ausrichtungsmarken stattfindet, frei wählen kann, solange die z-Position sich im Schärfentiefebereich der Optiken befindet.

Die Schnittpunkte der optischen Achsen befinden sich mit Vorzug in der Fokusebene der Optiken. Auflösung und Schärfentiefebereich sind zwei miteinander konkurrierende Parameter. Je größer die Auflösung, desto kleiner der Schärfentiefebereich und umgekehrt. Verwendet man also Optiken mit einem hohen Auflösungsvermögen, besitzen diese einen entsprechend geringen Schärfentiefebereich. Dadurch müssen die Ausrichtungsmarken des oberen und unteren Substrats sich gleichzeitig innerhalb eines sehr kleinen Schärfentiefebereichs aufhalten, um noch scharf abgebildet werden zu können. Erfindungsgemäß wird der Schnittpunkt der optischen Achsen im Schärfentiefebereich der korrespondierenden Optiken angeordnet. Die Auflösung der Optiken ist besser als 100 µm, vorzugsweise besser als 10 µm, noch bevorzugter besser als 1 µm, am bevorzugtesten besser als 500 nm, am allerbevorzugtesten besser als 200 nm.

Erfindungsgemäß ist es von Vorteil, wenn die Optiken so kalibriert werden, dass die Kontaktflächen und/oder die Ausrichtungsmarkierungen der Substrate in Erfassungspositionen der jeweiligen Erfassungseinheiten innerhalb der Schärfentiefebereiche angeordnet sind. Dadurch kann erfindungsgemäß auf eine Nachfokussierung verzichtet werden.

Der genannte Kalibrierprozess kann auch noch ausführlich in der Druckschrift WO2014202106A1 nachgelesen werden, deren Offenbarungsgehalt diesbezüglich in die Offenbarung der Erfindung aufgenommen wird.

In den beiden folgenden Verfahren wird des Öfteren von einer Zentrierung der Ausrichtungsmarken in Bezug zu den Optiken gesprochen. Im Allgemeinen ist damit gemeint, dass sich die Ausrichtungsmarken zumindest im Sichtbereich und im Schärfentiefebereich der Optik befinden müssen. Die Ausrichtungsmarken müssen sich im Allgemeinen nicht im Zentrum des Detektors befinden, der die Aufnahme der Ausrichtungsmarken über die Optiken erzeugt. Im weiteren Sinne dient die genannte Zentrierung vor allem immer dazu, zwei Ausrichtungsmarken unterschiedlicher Substrate zueinander auszurichten. In der Druckschrift wird das Wort Zentrierung aber exemplarisch enger verwendet, indem damit ein Zustand beschrieben wird, bei dem die Ausrichtungsmarken, insbesondere des ersten Substrats, bestmöglich im Zentrum der Optiken zu liegen kommen um eine möglichst optimale Situation der Vermessung zu schaffen.

### Erstes Verfahren

In einem ersten beispielhaften erfindungsgemäßen Verfahren erfolgt die Ausrichtung mehrere Substrate zueinander in Bezug auf nach außen gerichtete Ausrichtungsmarken eines ersten, untersten Substrats. Der genaue Prozessablauf ist wie folgt.

In einem **ersten** erfindungsgemäßen Verfahrensschritt **100** des ersten erfindungsgemäßen Verfahrens wird ein erstes, unterstes Substrat mit Ausrichtungsmarken auf einem unteren Substrathalter fixiert. Das erste Substrat wird dabei so auf dem Substrathalter fixiert, dass Ausrichtungsmarken durch Ausnehmungen des unteren Substrathalters sichtbar, insbesondere vermessbar, sind. Die Ausrichtungsmarken sind äußere Ausrichtungsmarken. Die Ausrichtungsmarken zeigen im Speziellen nach unten. Spezielle Ausführungsformen des unteren Substrathalters verlangen ein Überheben des Substrathalters über die Optik, sodass die unteren Optiken in den Ausnehmungen versenkt werden können. Ein Überheben wird vor allem auch dann notwendig, wenn der Substrathalter den Prozessbereich vollständig verlässt und sich daher, nach der ersten Positionierung in x- und y-Richtung, nicht nur mehr ausschließlich in der z-Richtung bewegt. In einer besonders bevorzugten erfindungsgemäßen Ausführungsform eines Substrathalters sind Zugangswege für die Optiken vorgesehen, entlang denen eine berührungsfreie Relativbewegung zwischen den Optiken und dem unteren Substrathalter erfolgen kann. Der untere Substrathalter wird nun solange grobpositioniert, bis sich die Ausrichtungsmarken in einem linken bzw. rechten Sichtfeld (engl.: field-of-view) der unteren Optiken befinden.

In einem **zweiten** erfindungsgemäßen Prozessschritt **101** des ersten erfindungsgemäßen Verfahrens verfährt der untere Substrathalter solange in z-Richtung, bis sich die beiden Ausrichtungsmarken im Schärfentiefebereich (engl.: depth-of-field) der Optiken befinden. Dabei kann es auch notwendig sein, einen Keilfehlerausgleich durchzuführen, um die Außenfläche des ersten Substrats parallel zur Fokusebene der Optiken auszurichten. Sobald beide Ausrichtungsmarken sich im Schärfentiefebereich befinden, werden sie scharf genug abgebildet, um vermessen zu werden.

In einem **dritten,** optionalen erfindungsgemäßen Prozessschritt **102** des ersten erfindungsgemäßen Prozesses werden dann die linke und/oder die rechte Erfassungseinheit solange in der x- und/oder y-Richtung verfahren, bis die linke untere Optik die linke Ausrichtungsmarke und die rechte untere Optik die rechte untere Ausrichtungsmarke zentriert. Diese Zentrierung ist streng genommen ein optionaler Schritt und muss nicht durchgeführt werden. Die Positionen der Ausrichtungsmarken können auch im Zustand des Prozessschrittes 101 vermessen und gespeichert werden. Dementsprechend werden sich die Ausrichtungsmarken der Substrate, welche auf dem ersten Substrat gestapelt werden sollen, auch weiter vom Zentrum der Optiken entfernt befinden. Der Fachmann auf dem Gebiet weiß allerdings, dass die Hard- und Software die Ausrichtungsmarken zweier zueinander auszurichtender Substrate immer korrekt vermessen und zueinander in Verbindung setzen kann, solange sie sich im Schärfentiefebereich und im Sichtbereich der Optik befinden. Vorzugsweise wird aber eine entsprechende Zentrierung durchgeführt.

In einem **vierten** erfindungsgemäßen Prozessschritt **103** des ersten erfindungsgemäßen Prozesses wird der untere Substrathalter vorzugsweise abgesenkt. Der untere Substrathalter muss mit hoher Präzession in z-Richtung bewegbar sein. Entsprechende Methoden um eine hochgenaue Bewegung zu bewerkstelligen, werden in anderen Teilen der Druckschrift erwähnt. Denkbar ist allerdings auch, dass der untere Substrathalter aus dem Prozessbereich verfährt und in einem späteren Prozessschritt wieder zurückkehrt. Das ist sehr stark abhängig von der verwendeten Ausrichtungsanlage. In diesem Fall muss vor allem die x- und/oder y-Positionierung des unteren Substrathalters sehr präzise sein. Insbesondere kann das Verfahren aus dem Prozessbereich mit einem Überheben des Substrathalters über die Optiken einhergehen, um eine Kollision zu vermeiden.

In einem **fünften** erfindungsgemäßen Prozessschritt **104** des ersten erfindungsgemäßen Prozesses wird der obere Substrathalter in den Prozessbereich verfahren. Der obere Substrathalter ist mit Vorzug so konstruiert, dass er sich nur in x- und y-Richtung bewegen kann. Denkbar wäre aber auch eine zusätzliche Motoreinheit die, insbesondere eine hochgenaue, Positionierung in z-Richtung gestattet. Nachdem ein oberes, zweites Substrat auf dem oberen Substrathalter fixiert wurde, wird der obere Substrathalter solange verfahren, bis die oberen, äußeren Ausrichtungsmarken von den oberen Optiken zentriert werden. Im weiteren Sinne wird durch diese Zentrierung auch die Ausrichtung des oberen Substrats zum unteren Substrat über deren Ausrichtungsmarken bewerkstelligt. Das entspricht einer Ausrichtung des oberen Substrats zum unteren Substrat anhand der Ausrichtungsmarken des oberen und unteren Substrats. Die Erfassungseinheiten dürfen nicht mehr bewegt werden.

In einem **sechsten** erfindungsgemäßen Prozessschritt **105** des ersten erfindungsgemäßen Prozesses erfolgt der Bondvorgang zwischen dem ersten Substrat und dem zweiten Substrat. Dabei erfolgt eine relative Annäherung der beiden Substrate zueinander. Die relative Annäherung geschieht erfindungsgemäß vorzugsweise durch eine Annäherung des unteren Substrathalters an den oberen Substrathalter. Denkbar ist aber auch, dass eines der beiden Substrate oder beide Substrate durch eine weitere Vorrichtung, nicht näher ausgeführte Vorrichtung, insbesondere symmetrisch, ausgebogen wird und es zu einer, insbesondere zentrischen, Kontaktierung der beiden Substrate bzw. Substratoberflächen kommt. Vorzugsweise wird immer das obere Substrat ausgebogen, da es sich bei dem oberen Substrat immer um ein einzelnes Substrat handelt, während im weiteren Verlauf des Prozesses sich der Substratstapel auf dem unteren Substrathalter bildet. Einen Substratstapel zu verbiegen kann komplizierter sein. Substrathalter zur Verbiegung werden insbesondere in den Druckschriften PCT/EP2016/056249 und WO2014191033A1 beschrieben und offenbart.

In einem **siebten** erfindungsgemäßen Prozessschritt **106** des ersten erfindungsgemäßen Prozesses liegt ein aus zwei Substraten bestehender Substratstapel vor, der über Ausrichtungsmarken an den Außenseiten beider Substrate verfügt. Insbesondere sind in diesem Zustand die beiden Substrate unlösbar, vorzugsweise schwer lösbar, miteinander verbunden, entweder durch einen Direktbond, insbesondere eine Prebond oder Fusionsbond oder durch einen Temporärbond, Bei einem Temporärbond ist insbesondere der Kleber bereits ausgehärtet worden, vorzugsweise thermisch, noch bevorzugter mittels Belichtung, vorzugsweise mittels UV Belichtung. Sollte durch einen anschließenden Metrologieschritt festgestellt werden, dass die Ausrichtung der beiden Substrate zueinander nicht optimal ist und es sich nur um einen schwer lösbare Verbindung, insbesondere um einen Prebond, handeln, kann vorzugsweise das Verfahren aus der Druckschrift WO2013091714A1 verwendet werden, um die beiden Substrate wieder voneinander zu trennen und um die beiden Substrate einer erneuten Prozessierung zuzuführen. Insbesondere sind die äußeren Ausrichtungsmarken des unteren Substrats, durch den Substratstapel betrachtet, deckungsgleich zu den äußeren Ausrichtungsmarken des oberen Substrats. Der erzeugte Substratstapel wird erneut in z-Richtung abgesenkt. Denkbar ist auch in diesem Fall, dass der erzeugte Substratstapel nicht abgesenkt, sondern wiederum aus dem Prozessbereich verfahren wird, um in einem späteren Prozessschritt wieder zurückzukehren. Insbesondere kann das Verfahren aus dem Prozessbereich mit einem Überheben des Substrathalters über die Optiken einhergehen, um eine Kollision zu vermeiden. In einer weiteren Ausführungsform kann es sogar notwendig sein, den so erzeugten Substratstapel in eine andere Anlage, Firma oder sogar ein anderes Land zu verschiffen, um die weiteren Prozessschritte an anderen Anlagen durchzuführen.

Von diesem Punkt an, kann der erste erfindungsgemäße Prozess mit beliebigen weiteren Substraten, die am oberen Substrathalter fixiert werden, weitergeführt und ab Prozessschritt 104 wiederholt werden. Der größte Fehler, der dabei auftreten kann, bezieht sich auf die fehlerhafte Ausrichtung zwischen dem untersten Substrat und dem obersten, zu bondenden Substrat. Eine Fehlerfortpflanzung der Ausrichtung über den Substratstapel hinweg unterbleibt.

In einem **neunten** erfindungsgemäßen Prozessschritt **108** des ersten erfindungsgemäßen Prozesses erhält man den endgültigen Substratstapel, der durch ein Entfernen des unteren Substrathalters aus dem Prozessbereich entfernt und danach entladen werden kann.

### Zweites Verfahren

In einem zweiten beispielhaften erfindungsgemäßen Verfahren erfolgt die Ausrichtung mehrere Substrate zueinander in Bezug auf nach innen gerichtete Ausrichtungsmarken eines ersten, untersten Substrats. Der Prozessablauf ist wie folgt.

In einem **ersten** erfindungsgemäßen Prozessschritt **200** des zweiten erfindungsgemäßen Verfahrens wird ein erstes, unterstes Substrat mit Ausrichtungsmarken auf dem unteren Substrathalter fixiert. Die Ausrichtungsmarken werden dabei von den oberen Optiken vermessen. Die Ausrichtungsmarken zeigen im Speziellen nach oben. In einer speziellen Ausführungsform können die Ausrichtungsmarken auch von Optiken auf der Unterseite vermessen werden. Das setzt allerdings voraus, dass das Substrat transparent für die elektromagnetische Strahlung sein muss, die von den unteren Optiken detektiert werden kann. Insbesondere sind Siliziumsubstrate infrarottransparent. Im weiteren Verlauf der Druckschrift wird der zweite erfindungsgemäße Prozess ausschließlich anhand der Oberseitenoptiken beschrieben, die direkt auf die zu vermessenden Ausrichtungsmarken gerichtet sind. Der untere Substrathalter wird nun solange grobpositioniert, bis sich die Ausrichtungsmarken im linken bzw. rechten Sichtfeld (engl.: field-of-view) der oberen Optiken befinden.

In einem **zweiten** erfindungsgemäßen Prozessschritt **201** des zweiten erfindungsgemäßen Prozesses verfährt der untere Substrathalter solange in z-Richtung, bis sich die beiden Ausrichtungsmarken im Schärfentiefebereich (engl.: depth-of-field) der oberen Optiken befinden. Dabei kann es auch notwendig sein, einen Keilfehlerausgleich durchzuführen, um die Außenfläche des unteren Substrats parallel zur Fokusebene der Optiken auszurichten. Sobald beide Ausrichtungsmarken sich im Schärfentiefebereich befinden, werden sie scharf genug abgebildet um vermessen zu werden.

In einem **dritten,** optionalen erfindungsgemäßen Prozessschritt **202** des zweiten erfindungsgemäßen Prozesses werden dann die linke und/oder die rechte Erfassungseinheit solange in der x- und/oder y-Richtung verfahren, bis die linke obere Optik die linke Ausrichtungsmarke und die rechte obere Optik die rechte untere Ausrichtungsmarke fokussiert. Die Überlegungen bezüglich Fokussierung sind identisch zu den Ausführungen im Prozessschritt 102 des ersten Prozesses und werden hier übernommen.

In einem **vierten** erfindungsgemäßen Prozessschritt **203** des zweiten erfindungsgemäßen Prozesses wird der untere Substrathalter abgesenkt. Der untere Substrathalter muss mit hoher Präzession in z-Richtung bewegbar sein. Entsprechende Methoden um eine hochgenaue Bewegung zu bewerkstelligen, werden in anderen Teilen der Druckschrift erwähnt. Denkbar ist allerdings auch, dass der untere Substrathalter aus dem Prozessbereich verfährt und in einem späteren Prozessschritt wieder zurückkehrt. Das ist sehr stark abhängig von der verwendeten Ausrichtungsanlage. In diesem Fall muss vor allem die x- und/oder y-Positionierung des unteren Substrathalters sehr präzise sein. Insbesondere kann das Verfahren aus dem Prozessbereich mit einem Überheben des Substrathalters über die Optiken einhergehen, um eine Kollision zu vermeiden. Alle weiteren Prozessschritte sind identisch zu den Prozessschritten 104-107.

In einem **fünften** erfindungsgemäßen Prozessschritt **204** des zweiten erfindungsgemäßen Prozesses wird der obere Substrathalter in den Prozessbereich verfahren. Der obere Substrathalter ist mit Vorzug so konstruiert, dass er sich nur in x- und y-Richtung bewegen kann. Denkbar wäre aber auch eine zusätzliche Motoreinheit die, insbesondere eine hochgenaue, Positionierung in z-Richtung gestattet. Nachdem das obere Substrat auf dem oberen Substrathalter fixiert wurde, wird der obere Substrathalter solange verfahren, bis die oberen Ausrichtungsmarken von den oberen Optiken zentriert werden. Im weiteren Sinne wird durch diese Zentrierung auch die Ausrichtung des oberen Substrats zum unteren Substrat über deren Ausrichtungsmarken bewerkstelligt. Das entspricht einer Ausrichtung des oberen Substrats zum unteren Substrat anhand der Ausrichtungsmarken des oberen und unteren Substrats. Die Erfassungseinheiten dürfen nicht mehr bewegt werden.

In einem **sechsten** erfindungsgemäßen Prozessschritt **205** des zweiten erfindungsgemäßen Prozesses erfolgt der Bondvorgang zwischen dem ersten Substrat und dem zweiten Substrat. Dabei erfolgt eine relative Annäherung der beiden Substrate zueinander. Die relative Annäherung geschieht erfindungsgemäß vorzugsweise durch eine Annäherung des unteren Substrathalters an den oberen Substrathalter. Denkbar ist aber auch, dass eines der beiden Substrate oder beide Substrate durch eine weitere Vorrichtung, nicht näher ausgeführte Vorrichtung, insbesondere symmetrisch, ausgebogen werden und des zu einer, insbesondere zentrischen, Kontaktierung der beiden Substrate bzw. Substratoberflächen kommt. Vorzugsweise wird immer das obere Substrat ausgebogen, da es sich bei dem oberen Substrat immer um ein einzelnes Substrat handelt, während im weiteren Verlauf des Prozesses sich der Substratstapel auf dem unteren Substrathalter bildet. Einen Substratstapel zu verbiegen kann komplizierter sein.

In einem **siebten** erfindungsgemäßen Prozessschritt **206** des zweiten erfindungsgemäßen Prozesses liegt ein, aus zwei Substraten bestehender, Substratstapel vor, der nur an seinem oberen Substrat über Ausrichtungsmarken verfügt. Der erzeugte Substratstapel wird erneut in z-Richtung abgesenkt. Denkbar ist auch in diesem Fall, dass der erzeugte Substratstapel nicht abgesenkt, sondern wiederum aus dem Prozessbereich verfahren wird, um in einem späteren Prozessschritt wieder zurückzukehren. Insbesondere kann das Verfahren aus dem Prozessbereich mit einem Überheben des Substrathalters über die Optiken einhergehen, um eine Kollision zu vermeiden. In einer weiteren Ausführungsform kann es sogar notwendig sein, den so erzeugten Substratstapel in eine andere Anlage, Firma oder sogar ein anderes Land zu verschiffen, um die weiteren Prozessschritte an anderen Anlagen durchzuführen.

Von diesem Punkt an, kann der zweite erfindungsgemäße Prozess mit beliebigen weiteren Substraten, die am oberen Substrathalter fixiert werden, weitergeführt und ab Prozessschritt 204 wiederholt werden. Der größte Fehler der dabei auftreten kann bezieht sich auf die fehlerhafte Ausrichtung zwischen dem untersten Substrat und dem obersten, zu bondenden Substrat. Eine Fehlerfortpflanzung der Ausrichtung über den Substratstapel hinweg unterbleibt.

In einem **neunten** erfindungsgemäßen Prozessschritt **208** des zweiten erfindungsgemäßen Prozesses erhält man dann den endgültigen Substratstapel, der durch ein Entfernen des unteren Substrathalters aus dem Prozessbereich entfernt und danach entladen werden kann.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen schematisch in:
- Fig. 1a: drei verschiedene Möglichkeiten von Stellungen von optischen Achsen zweier Optiken zueinander,
- Fig. 1b: drei weitere Möglichkeiten von Stellungen von optischen Achsen zweier Optiken zueinander,
- Fig. 2a: einen ersten Schritt eines ersten erfindungsgemäßen Verfahrens,
- Fig. 2b: einen zweiten Schritt des ersten erfindungsgemäßen Verfahrens,
- Fig. 2c: einen dritten, optionalen Schritt des ersten erfindungsgemäßen Verfahrens,
- Fig. 2d: einen vierten Schritt des ersten erfindungsgemäßen Verfahrens,
- Fig. 2e: einen fünften Schritt des ersten erfindungsgemäßen Verfahrens,
- Fig. 2f: einen sechsten Schritt des ersten erfindungsgemäßen Verfahrens,
- Fig. 2g: einen siebten Schritt des ersten erfindungsgemäßen Verfahrens,
- Fig. 2h: einen achten Schritt des ersten erfindungsgemäßen Verfahrens,
- Fig. 2i: einen neunten Schritt des ersten erfindungsgemäßen Verfahrens,
- Fig. 3a: einen ersten Schritt eines zweiten erfindungsgemäßen Verfahrens,
- Fig. 3b: einen zweiten Schritt des zweiten erfindungsgemäßen Verfahrens
- Fig. 3c: einen dritten, optionalen Schritt des zweiten erfindungsgemäßen Verfahrens,
- Fig. 3d: einen vierten Schritt des zweiten erfindungsgemäßen Verfahrens,
- Fig. 3e: einen fünften Schritt des zweiten erfindungsgemäßen Verfahrens,
- Fig. 3f: einen sechsten Schritt des zweiten erfindungsgemäßen Verfahrens,
- Fig. 3g: einen siebten Schritt des zweiten erfindungsgemäßen Verfahrens,
- Fig. 3h: einen achten Schritt des zweiten erfindungsgemäßen Verfahrens,
- Fig. 3i: einen neunten Schritt des zweiten erfindungsgemäßen Verfahrens,
- Fig. 4a: eine schematische, nicht maßstabsgetreue Oberansicht eines ersten erfindungsgemäßen Substrathalters,
- Fig. 4b: eine schematische, nicht maßstabsgetreue Oberansicht eines zweiten erfindungsgemäßen Substrathalters,
- Fig. 5a: ein erstes Flussdiagramm,
- Fig. 5b: ein zweites Flussdiagramm,
- Fig. 6a: einen Substratstapel hergestellt mit einem Verfahren nach dem Stand der Technik und
- Fig. 6b: einen Substratstapel hergestellt mit einem erfindungsgemäßen Verfahren.

In den Figuren sind gleiche Bauteile oder Bauteile mit der gleichen Funktion mit den gleichen Bezugszeichen gekennzeichnet.

Die Druckschrift US 6214692 B1 offenbart eine beispielhafte Vorrichtung zur Durchführung der folgenden Verfahren. Daher wird die Offenbarung dieser Druckschrift in diese Beschreibung einbezogen.

Eine linke Erfassungseinheit 81 weist eine untere linke Optik 7ul und eine obere linke Optik 7ol auf. Eine rechte Erfassungseinheit 8r weist eine untere rechte Optik 7ur und eine obere rechte Optik 7or auf.

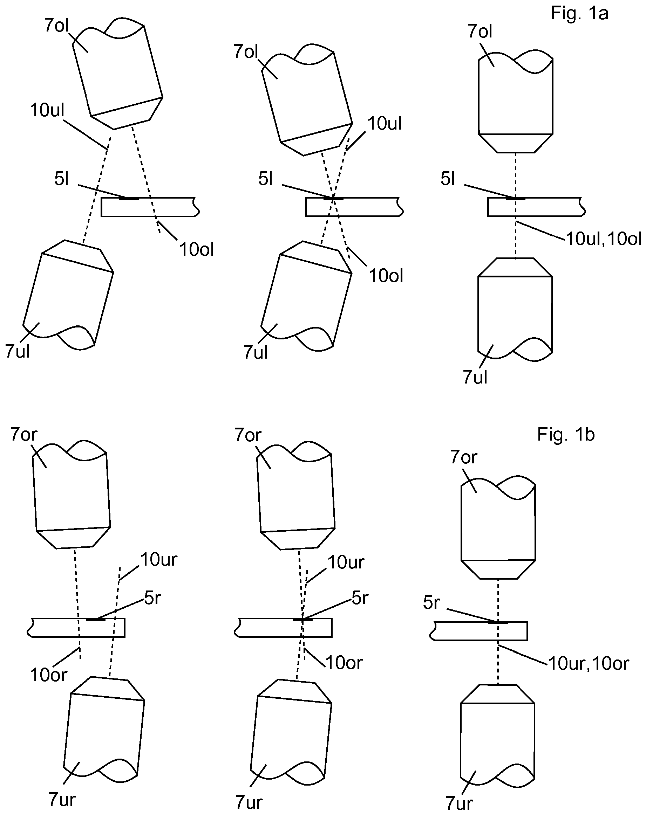

Die **Figur 1a** zeigt drei verschiedene Möglichkeiten von Stellungen von optischen Achsen 10ol, 10ul der linken Optiken 7ul, 7ol zueinander. Im ersten Fall (links) gibt es keinen Schnittpunkt der optischen Achsen 10ul,10ol. Im zweiten Fall (Mitte) schneiden sich die optischen Achsen 10ul,10ol in einer linken Ausrichtungsmarke 51 auf einem Substrat. Das ist der am häufigsten auftretende Fall. Im dritten Fall (rechts), sind die beiden optischen Achsen 10ul,10ol kollinear (deckungsgleich) und durchstoßen die linke Ausrichtungsmarke 5l zentrisch. Hierbei handelt es sich um den optimalen Fall. Vor dem erfindungsgemäßen Verfahren werden die Optiken 7ol,7ul derart kalibriert, dass wenigstens der mittlere (zweite) Fall realisiert wird, wenn möglich soll der rechte (dritte) Fall realisiert werden.

Die **Figur 1b** zeigt drei verschiedene Möglichkeiten von Stellung von optischen Achsen 10or, 10ur der rechten Optiken 7ur, 7or zueinander. Im ersten Fall (links) gibt es keinen Schnittpunkt. Im zweiten Fall (Mitte) schneiden sich die optischen Achsen 10or, 10ur in einer rechten Ausrichtungsmarke 5r. Das ist der am häufigsten auftretende Fall. In dritten Fall (rechts), sind die beiden optischen Achsen 10or, 10ur kollinear und durchstoßen die rechte Ausrichtungsmarke 5r zentrisch. Hierbei handelt es sich um den optimalen Fall. Vor dem erfindungsgemäßen Verfahren werden die Optiken 7or,7ur derart kalibriert, dass wenigstens der mittlere Fall realisiert wird, wenn möglich soll der rechte Fall realisiert werden.

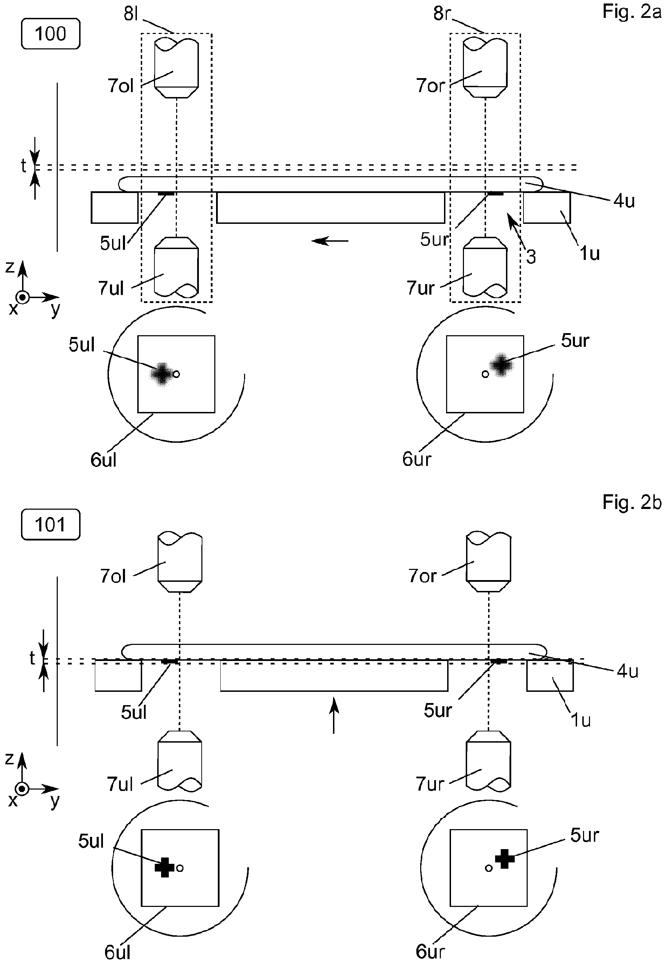

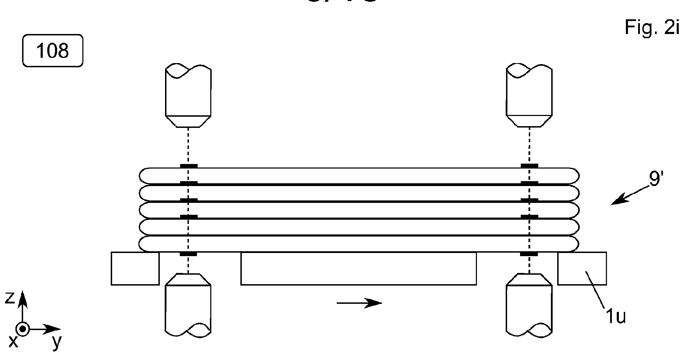

Die **Figur 2a** zeigt einen ersten Prozessschritt 100 eines ersten beispielhaften erfindungsgemäßen Verfahrens.

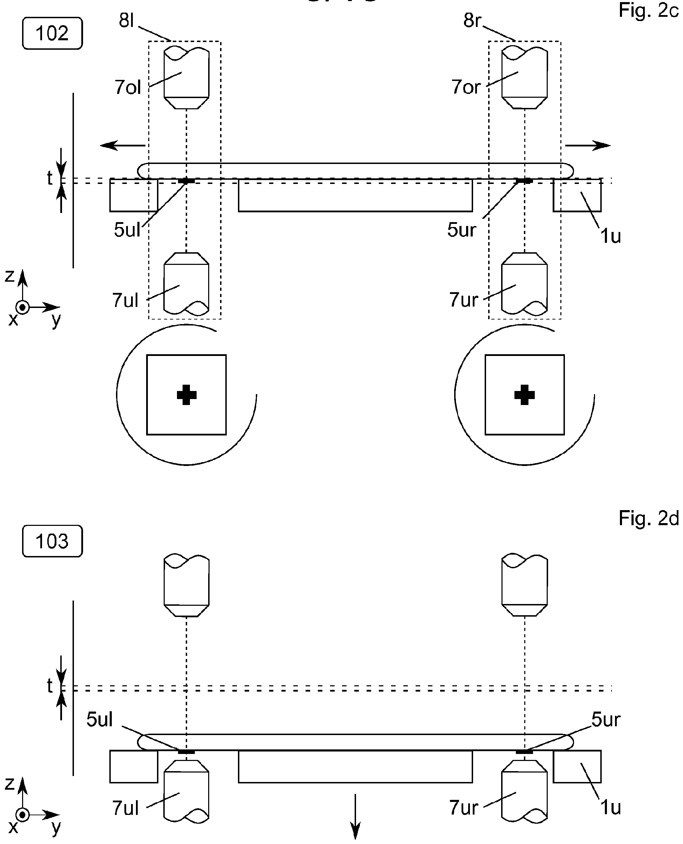

Ein unteres Substrat 4u weist eine untere, linke Ausrichtungsmarke 5ul und eine untere, rechte Ausrichtungsmarke 5ur auf und wird so auf einem unteren Substrathalter 1u fixiert, dass die Ausrichtungsmarken 5ul, 5ur für die untere linke Optik 7ul und die untere rechte Optik 7ur durch Ausnehmungen 3 im Substrathalter 1u erkennbar und vermessbar sind (siehe obere Abbildung der Figur 2a). Im Allgemeinen befinden sich die Ausrichtungsmarken 5ul, 5ur zu diesem Zeitpunkt noch nicht in einem Schärfentiefebereich t der Optiken 7ul,7ur, wodurch die Ausrichtungsmarken 5ul, 5ur entsprechend unscharf erscheinen. Die Ausrichtungsmarken 5ul, 5ur sollten sich aber vorzugsweise zumindest bereits in Sichtbereichen 6ul, 6ur der Optiken 7ul,7ur befinden (siehe untere Abbildungen). Das kann durch eine mechanische Vorjustierung erreicht werden (mit dem Pfeil angedeutet). Befinden sich die Ausrichtungsmarken 5ul, 5ur noch nicht in den Sichtbereichen 6ul, 6ur, müssen die Erfassungseinheiten 8l, 8r zumindest solange in x- und/oder y-Richtung verfahren werden, bis die Ausrichtungsmarken 5ul, 5ur für die unteren Optiken 7ul, 7ur sichtbar werden. Die genaue Ausrichtung der Erfassungseinheiten 8l, 8r auf die Ausrichtungsmarken 5ul, 5ur erfolgt erst in Fig. 2c. Die Optiken 7ul, 7ur dürfen nicht individuell bewegt werden, da sonst die vorher durchgeführte Kalibrierung verloren gehen würde.

Die **Figur 2b** zeigt einen zweiten Prozessschritt 101 des Verfahrens. Der untere Substrathalter lu wird solange in Z-Richtung verfahren (mit dem Pfeil angedeutet), bis sich die beiden Ausrichtungsmarken 5ul, 5ur des unteren Substrats 4u im Schärfentiefebereich t befinden. In diesem Prozessschritt kann, falls notwendig, auch ein Keilfehlerausgleich durchgeführt werden. Ein Keilfehler kann dadurch erkennbar sein, dass eine der beiden Ausrichtungsmarken 5ul, 5ur unscharf abgebildet wird, da sie sich außerhalb des Schärfentiefebereichs t befindet, während die zweite der Ausrichtungsmarken 5ul, 5ur scharf abgebildet wird, weil sie sich noch innerhalb des Schärfentiefebereichs t befindet. Vorzugsweise wird der Keilfehler aber durch präzisere Messvorrichtungen, insbesondere durch Interferometer, erkannt und durch Kippung des unteren Substrathalters 1u entsprechend korrigiert.

Die **Figur 2c** zeigt einen dritten, optionalen Prozessschritt 102. Die Erfassungseinheiten 8l, 8r werden dabei solange in X- und/oder Y-Richtung verfahren (mit dem Pfeil angedeutet), bis die Ausrichtungsmarken 5ul, 5ur durch die unteren Optiken 7ul, 7ur zentriert wurden bzw. bis die Ausrichtungsmarken 5ul, 5ur zentriert in den Optiken 7ul,7ur dargestellt werden. Die Ausrichtungsmarken 5ul, 5ur fallen dann möglichst genau, vorzugsweise exakt, mit den Schnittpunkten der optischen Achsen der Optiken 7ul, 7ol bzw. 7ur, 7or zusammen. Die Erfassungseinheiten 8l, 8r mit den Optiken 7ul,7ur,7ol,7or werden daraufhin fixiert und während des erfindungsgemäßen Prozesses nicht mehr bewegt. Die Translationspositionen und/oder Rotationspositionen des unteren Substrathalters 1u werden gespeichert.

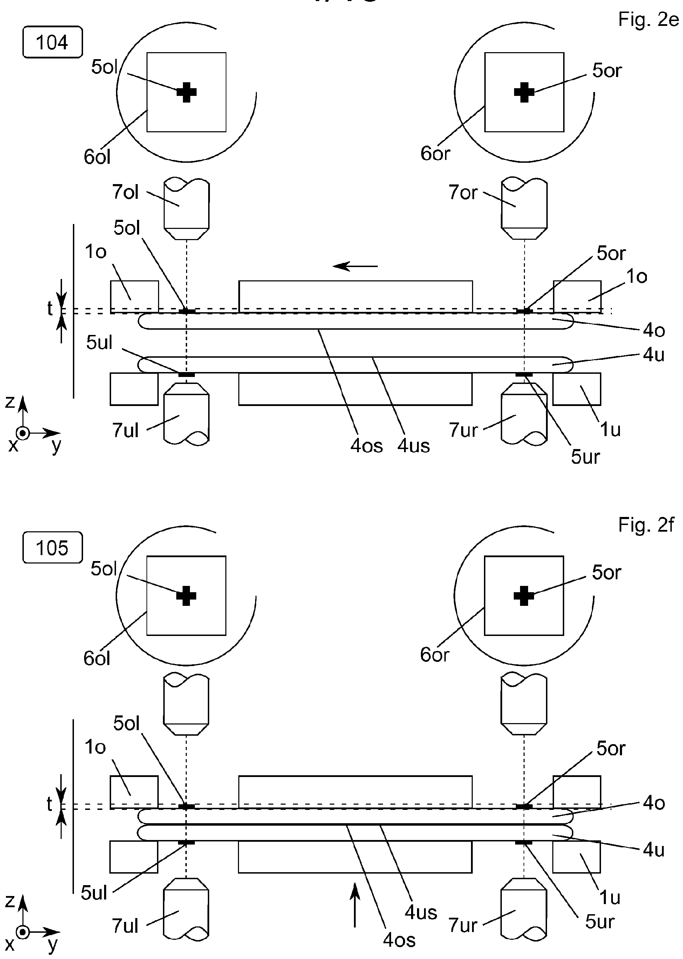

Die **Figur 2d** zeigt einen vierten Prozessschritt 103. Das untere Substrat 1u wird in die negative z-Richtung verfahren (mit dem Pfeil angedeutet), um einen Prozessbereich für einen oberen Substrathalter 1o (nicht dargestellt) frei zu machen. Dabei ist es notwendig, den unteren Substrathalters 1u möglichst präzise zu verfahren. Möglichst präzise bedeutet, dass die Abweichung des unteren Substrathalters 1u in x- und/oder y-Richtung mit Bewegung in z-Richtung minimal sein muss. In einer alternativen erfindungsgemäßen Ausführungsform kann der Substrathalter 1u auch aus dem Prozessbereich verfahren werden. Der Substrathalter 1u muss dann vor dem Prozessschritt 105 aus Fig. 2f wieder in den Prozessbereich verfahren werden.

Die **Figur 2e** zeigt einen fünften Prozessschritt 104. Der obere Substrathalter 1o positioniert (mit dem Pfeil angedeutet) ein geladenes und fixiertes, oberes Substrat 4o so (siehe untere Abbildung), dass obere Ausrichtungsmarken 5ol, 5or auf der Oberseite des oberen Substrats 4o sich in Sichtbereichen 6ol, 6or der oberen Optiken 7ol, 7or befinden und korrekt zentriert werden (siehe obere Abbildungen). Der obere Substrathalter 1o ist vorzugsweise so konstruiert, dass nur eine Bewegung in x- und y-Richtung aber nicht in z-Richtung möglich ist. Durch das Beladen des oberen Substrats 4o auf den oberen Substrathalter 1o befinden sich daher die oberen Ausrichtungsmarken 5ol, 5or vorzugsweise bereits im Schärfentiefebereich t. Denkbar ist allerdings auch eine Vorrichtung, bei der der obere Substrathalter 1o sehr wohl, zumindest über kurze Distanzen, in z-Richtung verfahren werden kann, um kleine Höhenfehler auszugleichen.

Insbesondere erfolgt der Prozessschritt 103 aus Figur 2d und der Prozessschritt 104 aus Figur 2e simultan.

Die **Figur 2f** zeigt einen sechsten Prozessschritt 105. In diesem Prozessschritt erfolgt der Fixier- und/oder Bondvorgang der beiden Substrate 4u, 4o. Im Allgemeinen kommt es zu einer relativen Annäherung der beiden Substrate 4u und 4o. In einer speziellen, dargestellten erfindungsgemäßen Ausführungsform fährt der untere Substrathalter 1u das untere Substrat 4u in Z-Richtung auf Kontakt mit dem oberen Substrat 4o (mit dem Pfeil angedeutet). Ein sehr wichtiger Aspekt besteht darin, dass zum Zeitpunkt des Kontaktes zwischen einer oberen Substratoberfläche 4us des unteren Substrats 4u und einer unteren Substratoberfläche 4os des oberen Substrats 4o, die Abweichung des unteren Substrathalters 1u in x- und/oder y-Richtung in Bezug zur idealen x- und/oder y-Position minimal ist. In einer anderen erfindungsgemäßen Ausführungsform wäre es in diesem Prozessschritt auch möglich, den oberen Substrathalter 1o an den unteren Substrathalter 1u anzunähern. Es gelten dann analoge Überlegungen für die hochpräzise Positionierung in z-Richtung. In einer ganz speziellen erfindungsgemäßen Ausführungsform würden sich beide Substrathalter 1u und 1o aneinander annähern.

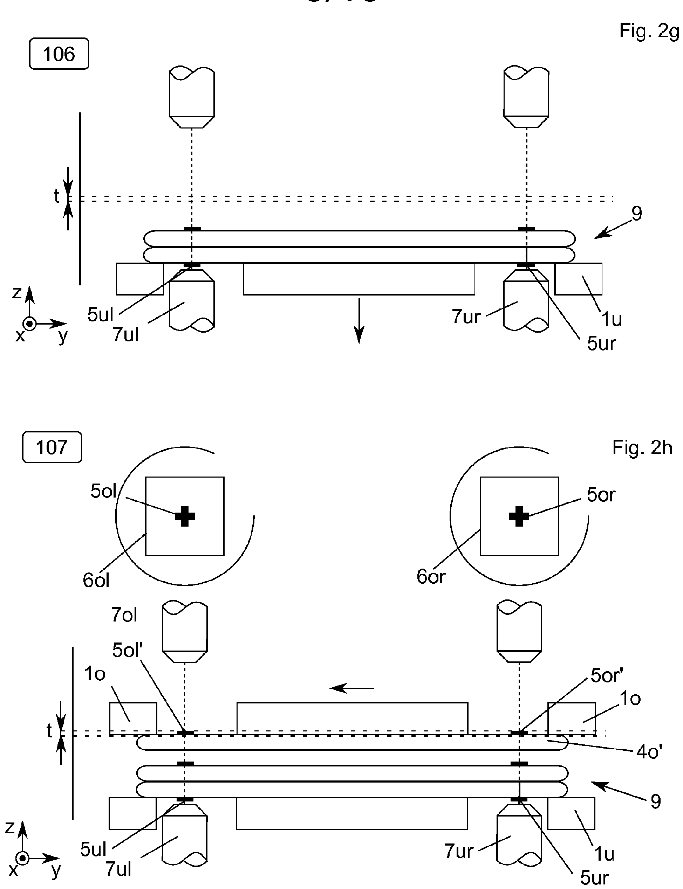

Die **Figur 2g** zeigt einen siebten Prozessschritt 106, bei dem der untere Substrathalter 1u mit einem gebildeten Substratstapel 9, der aus den ersten beiden gebondeten Substraten 4u, 4o besteht, in die negative z-Richtung verfahren wird (mit dem Pfeil angedeutet), um den Prozessbereich für den oberen Substrathalter 1o freizumachen. Denkbar ist auch, dass der Substrathalter 1u den Prozessbereich verlässt und zu einem Zeitpunkt vor dem nächsten Bondvorgang zurückkehrt. Die Prozessschritte 104-106 können jetzt mehrmals durchgeführt werden.

Die **Figur 2h** zeigt einen achten Prozessschritt 107, bei dem ein drittes Substrat 4o' mit Ausrichtungsmarkierungen Sol`,Sor` auf seiner Oberseite vom oberen Substrathalter fixiert und über dem Substratstapel 9 angeordnet wird. Analog Fig. 2e bzw. Schritt 104 positioniert der obere Substrathalter 1o (mit dem Pfeil angedeutet) das geladene und fixierte, weitere obere Substrat 4o' so (siehe untere Abbildung), dass die oberen Ausrichtungsmarken 5ol', 5or' auf der Oberseite des oberen Substrats 4o sich in den Sichtbereichen 6ol, 6or der oberen Optiken 7ol, 7or befinden und korrekt zentriert werden (siehe obere Abbildungen). Der obere Substrathalter 1o ist vorzugsweise so konstruiert, dass nur eine Bewegung in x- und y-Richtung aber nicht in z-Richtung möglich ist. Durch das Beladen des oberen Substrats 4o' auf den oberen Substrathalter 1o befinden sich daher die oberen Ausrichtungsmarken 5ol', 5or` vorzugsweise bereits im Schärfentiefebereich t. Denkbar ist allerdings auch eine Vorrichtung, bei der der obere Substrathalter 1o sehr wohl, zumindest über kurze Distanzen, in z-Richtung verfahren werden kann, um kleine Höhenfehler auszugleichen.

Es folgt der Bondvorgang analog Fig. 2f bzw. Schritt 105 sowie das Freimachen des Prozessbereichs analog Figur 2g bzw. Schritt 106.

Danach können weitere Substrate analog den Schritte 107,105,106 ausgerichtet und gebondet werden. Erfindungsgemäß wird das zu bondende Substrat n+1 zum ersten Substrat und nicht zum n-ten Substrat ausgerichtet, sodass der Ausrichtungsfehler minimiert werden kann.

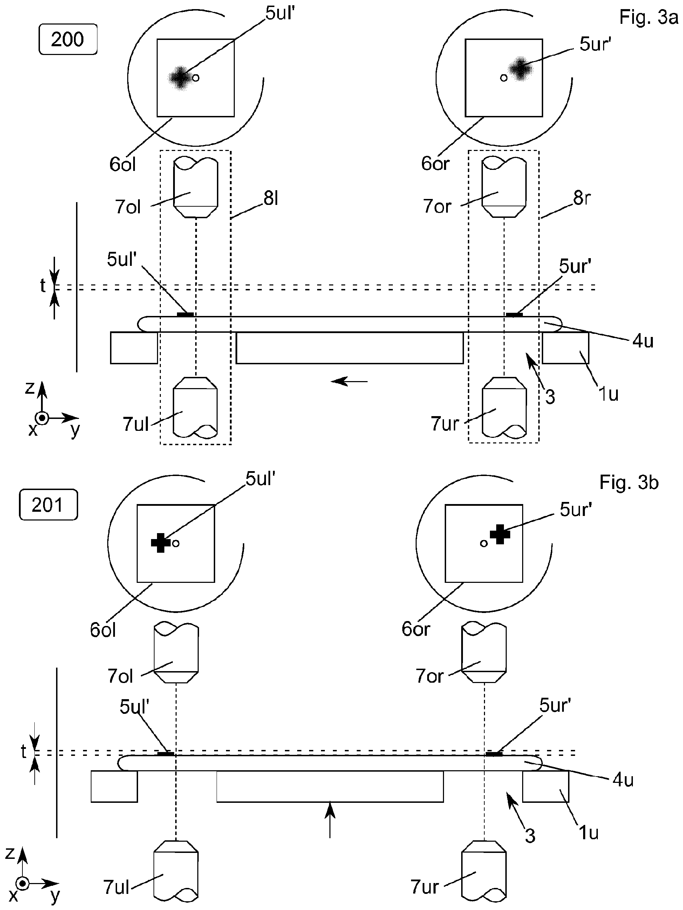

Die **Figur 3a** zeigt einen ersten Verfahrensschritt 200 eines zweiten beispielhaften erfindungsgemäßen Verfahrens. Eine linke untere Ausrichtungsmarke 5ul' und eine rechte untere Ausrichtungsmarke 5ur' sind auf der Oberseite des unteren Substrats 4u angeordnet (siehe untere Abbildung). Im Allgemeinen befinden sich die Ausrichtungsmarken 5ul', 5ur' zu diesem Zeitpunkt noch nicht im Schärfentiefebereich t der Optiken 7ol,7or, wodurch die Ausrichtungsmarken 5ul', 5ur' entsprechend unscharf erscheinen (siehe obere Abbildungen). Die Ausrichtungsmarken 5ul', 5ur' sollten sich aber vorzugsweise zumindest bereits in den Sichtbereichen 6ol, 6or befinden. Das kann durch eine mechanische Vorjustierung immer erreicht werden. Befinden sich die Ausrichtungsmarken 5ul", 5ur' noch nicht in den Sichtbereichen 6ol, 6or, müssen die Erfassungseinheiten 8l, 8r solange in x- und/oder y-Richtung verfahren werden, bis die Ausrichtungsmarken 5ul', 5ur' für die oberen Optiken 7ol, 7or sichtbar werden. Im Gegensatz zum ersten Prozess werden vorzugsweise nur die oberen Optiken 7ol und 7or verwendet. Dennoch werden die Erfassungseinheiten 8l, 8r als Ganzes bewegt. Die unteren Optiken 7ul, 7ur könnten eingesetzt werden um die Ausrichtungsmarken 5ul', 5ur' zu detektieren, sofern das Substrat 4u transparent ist. In diesem Fall wäre eine Beobachtung aller Ausrichtungsmarken 5ul', 5ur', 5ol, 5or von der Oberseite und eine Beobachtung der Ausrichtungsmarken 5ul', 5ur' von der Unterseite möglich. Am erfindungsgemäßen Prozess würde sich allerdings nichts ändern, da auch in diesem Fall die Kalibrierung eines jeden Substrats auf das jeweils erste Substrat erfolgt. In den weiteren Figuren werden die unteren Optiken 7ul, 7or daher zwar noch dargestellt, aber nicht weiter beschrieben.

Die **Figur 3b** zeigt einen zweiten Verfahrensschritt 201 des zweiten erfindungsgemäßen Verfahrens. Der untere Substrathalter 1u wird solange in Z-Richtung verfahren, bis sich die beiden Ausrichtungsmarken 5ul', 5ur' des unteren Substrats 4u im Schärfentiefebereich t befinden. In diesem Prozessschritt kann, falls notwendig, auch ein Keilfehlerausgleich durchgeführt werden. Ein Keilfehler kann dadurch erkennbar sein, dass eine der beiden Ausrichtungsmarken 5ul', 5ur' unscharf abgebildet wird, da sie sich außerhalb Schärfentiefebereich t befindet, während die zweite der Ausrichtungsmarken 5ul', 5ur' scharf abgebildet wird, weil sie sich noch innerhalb des Schärfentiefebereich t befindet. Vorzugsweise wird der Keilfehler aber durch präzisere Messvorrichtungen, insbesondere durch Interferometer erkannt und durch Kippung des unteren Substrathalters 1u entsprechend korrigiert.

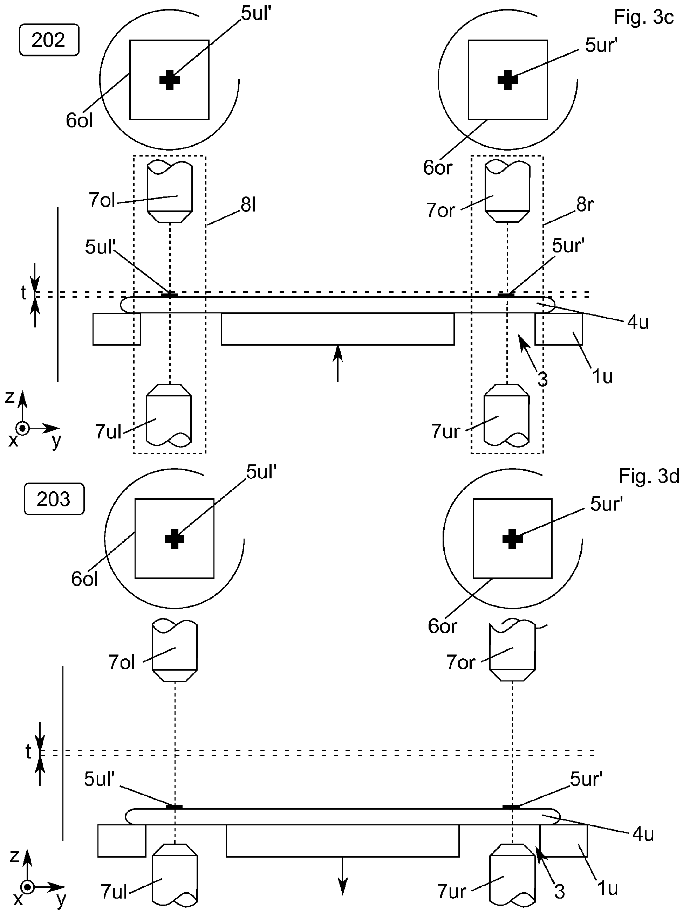

Die **Figur 3c** zeigt einen dritten, optionalen Prozessschritt 202. Die Erfassungseinheiten 8l, 8r werden dabei solange in Z-Richtung verfahren, bis die Ausrichtungsmarken 5ul', 5ur' durch die oberen Optiken 7ol, 7or zentriert wurden. Die Erfassungseinheiten 8l und 8r werden daraufhin fixiert und während des erfindungsgemäßen Prozesses nicht mehr bewegt. Die Translationspositionen und/oder Rotationspositionen des unteren Substrathalters 1u werden gespeichert.

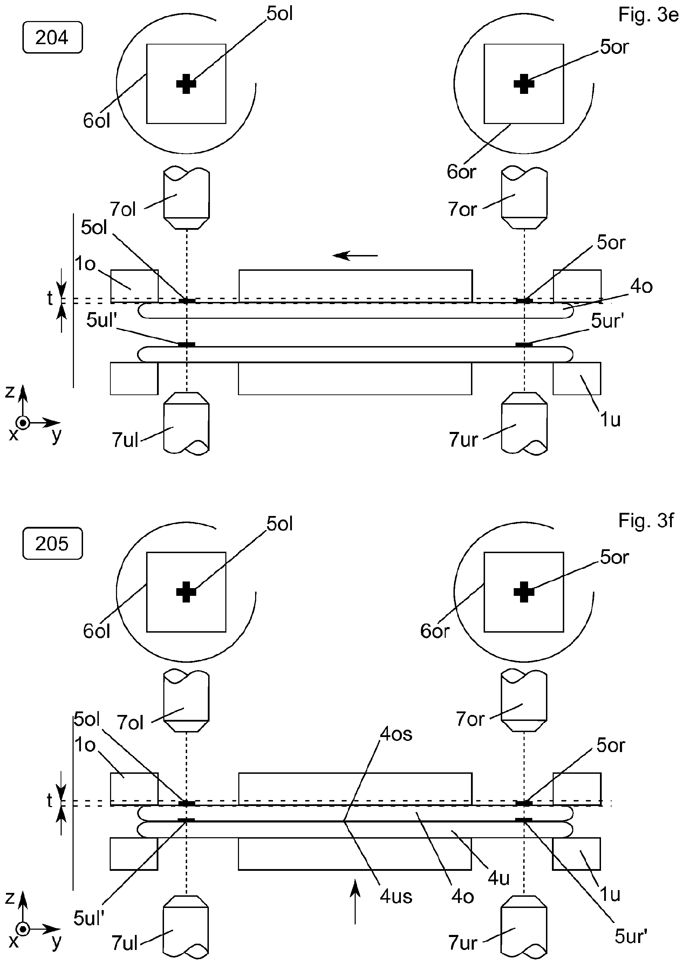

Die **Figur 3d** zeigt einen vierten Prozessschritt 203. Das untere Substrat 1u wird in die negative z-Richtung verfahren, um den Prozessbereich für den oberen Substrathalter 1o frei zu machen. Dabei ist es notwendig, den unteren Substrathalter 1u möglichst präzise zu verfahren, Möglichst präzise bedeutet, dass die Abweichung des unteren Substrathalters 1u in x- und/oder y-Richtung mit Bewegung in z-Richtung minimal sein muss. In einer alternativen erfindungsgemäßen Ausführungsform kann der Substrathalter 1u auch aus dem Prozessbereich verfahren werden. Der Substrathalter 1u muss dann vor dem Prozessschritt 205 aus Fig. 3f wieder in den Prozessbereich verfahren werden.

Die **Figur 3e** zeigt einen fünften Prozessschritt 204. Der obere Substrathalter 1o positioniert das geladene und fixierte, obere Substrat 4o so, dass die oberen Ausrichtungsmarken 5ol, 5or sich in den Sichtbereichen 6ol, 6or der oberen Optiken 7ol, 7or befinden und korrekt zentriert werden. Der obere Substrathalter 1o ist vorzugsweise so konstruiert, dass nur eine Bewegung in x- und y-Richtung aber nicht in z-Richtung möglich ist. Durch das Beladen des oberen Substrats 4o auf den oberen Substrathalter 1o befinden sich daher die oberen Ausrichtungsmarken 5ol, 5or vorzugsweise bereits im Schärfentiefebereich t. Denkbar ist allerdings auch eine Vorrichtung, bei der der obere Substrathalter 4o sehr wohl, zumindest über kurze Distanzen, in z-Richtung verfahren werden kann, um kleine Höhenfehler auszugleichen.

Insbesondere erfolgt der Prozessschritt 203 aus Figur 3d und der folgende Prozessschritt 204 aus Figur 3f simultan.

Die **Figur 3f** zeigt einen sechsten Prozessschritt 205. In diesem Prozessschritt erfolgt der Fixier- oder Bondvorgang der beiden Substrate 4u, 4o. Im Allgemeinen kommt es zu einer relativen Annäherung der beiden Substrate 4u und 4o. In einer speziellen, dargestellten erfindungsgemäßen Ausführungsform fährt der untere Substrathalter 1u das untere Substrat 4u auf Kontakt mit dem oberen Substrat 4o. Ein erfindungsgemäßer, sehr wichtiger Aspekt besteht darin, dass zum Zeitpunkt des Kontaktes zwischen der Substratoberfläche 4us und der Substratoberfläche 4os die Abweichung des unteren Substrathalters 1u in x- und/oder y-Richtung in Bezug zur idealen x- und/oder y-Position minimal ist. In einer anderen erfindungsgemäßen Ausführungsform wäre es in diesem Prozessschritt auch möglich, den oberen Substrathalter 1o an den unteren Substrathalter 1u anzunähern. Es gelten dann analoge Überlegungen für die hochpräzise Positionierung in z-Richtung. In einer ganz speziellen erfindungsgemäßen Ausführungsform würden sich beide Substrathalter 1u und 1o aneinander annähern.

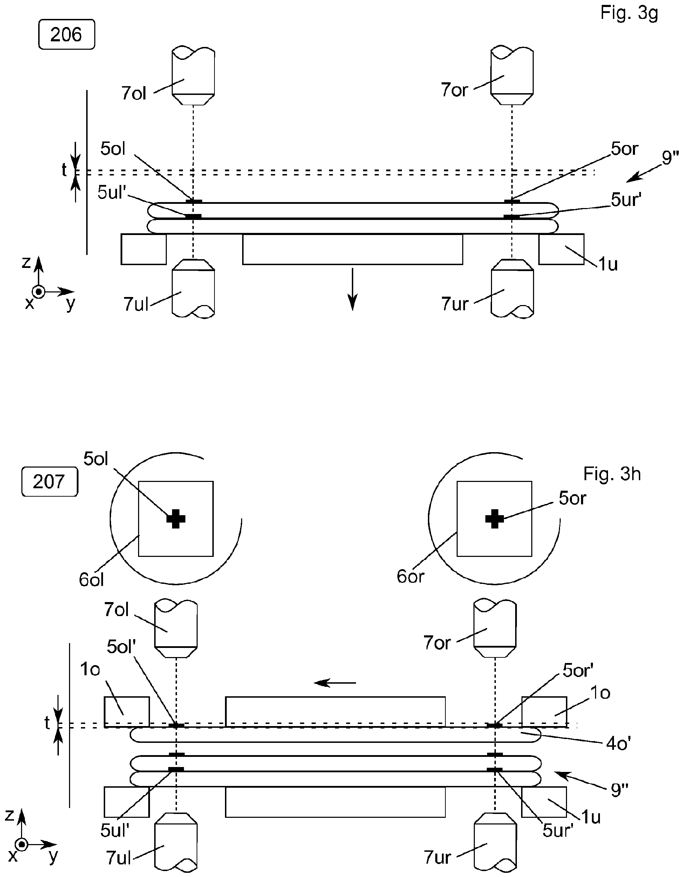

Die **Figur 3g** zeigt einen siebten Prozessschritt 206, bei dem der gebildete Substratstapel 9", der aus den ersten beiden Substraten 4u, 4o gebondet wurde, in die negative z-Richtung verfahren wird, um den Prozessbereich für den oberen Substrathalter lo, freizumachen. Denkbar ist auch, dass der Substrathalter 1u den Prozessbereich verlässt und zu einem Zeitpunkt vor dem nächsten Bondvorgang zurückkehrt. Die Prozessschritte 204-206 können jetzt mehrmals durchgeführt werden.

Die **Figur 3h** zeigt einen achten Prozessschritt 207, bei dem ein drittes Substrat 4o' mit Ausrichtungsmarkierungen 5ol',5or' auf seiner Oberseite vom oberen Substrathalter fixiert und über dem Substratstapel 9" angeordnet wird. Analog Fig. 3e bzw. Schritt 204 positioniert der obere Substrathalter 1o (mit dem Pfeil angedeutet) das geladene und fixierte, weitere obere Substrat 4o' so (siehe untere Abbildung), dass die oberen Ausrichtungsmarken 50l', 5or' auf der Oberseite des oberen Substrats 4o sich in den Sichtbereichen 6ol, 6or der oberen Optiken 7ol, 7or befinden und korrekt zentriert werden (siehe obere Abbildungen). Der obere Substrathalter 1o ist vorzugsweise so konstruiert, dass nur eine Bewegung in x- und y-Richtung aber nicht in z-Richtung möglich ist. Durch das Beladen des oberen Substrats 4o' auf den oberen Substrathalter 1o befinden sich daher die oberen Ausrichtungsmarken 5ol', 5or' vorzugsweise bereits im Schärfentiefebereich t. Denkbar ist allerdings auch eine Vorrichtung, bei der der obere Substrathalter 1o sehr wohl, zumindest über kurze Distanzen, in z-Richtung verfahren werden kann, um kleine Höhenfehler auszugleichen.

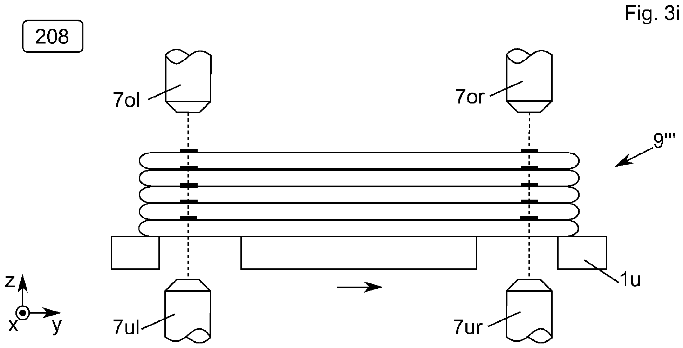

Die **Figur 3i** zeigt einen achten Prozessschritt 207, bei dem der vollständige Substratstapel 9" vom unteren Substrathalter 1u entladen wird.

Im Übrigen gilt für den zweiten Prozess das zum ersten Prozess ausgeführte.

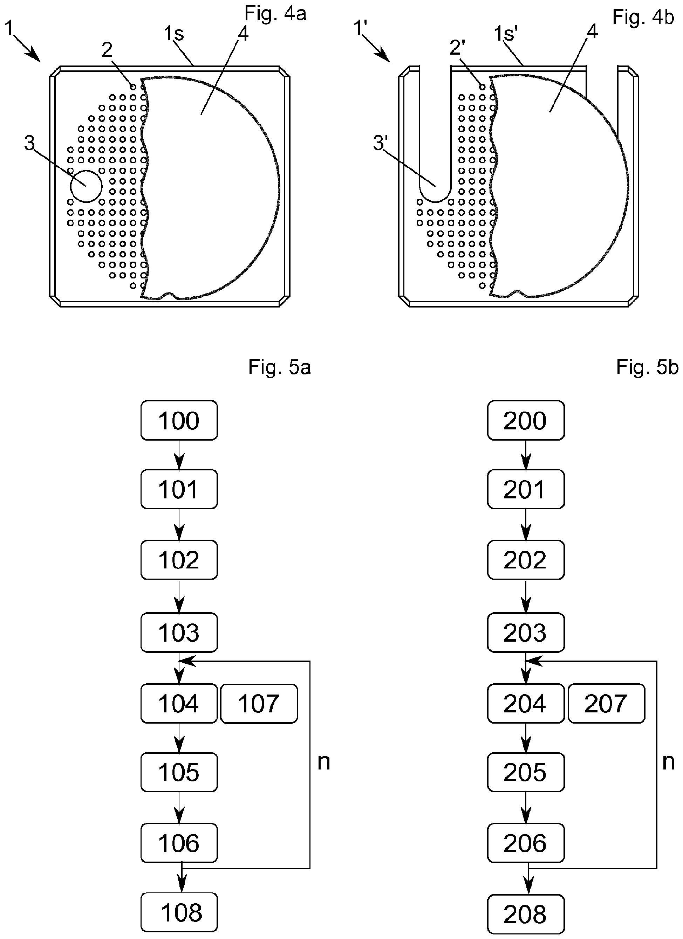

Die **Figur 4a** zeigt eine schematische, nicht maßstabsgetreue Oberansicht eines ersten erfindungsgemäßen Substrathalters 1, bestehend aus einer Substrathalterplatte, auf der, insbesondere mehrere, Fixierelemente 2 zur Fixierung eines Substrats 4 (nur teilweise dargestellt) vorhanden sind. Bei den Fixierelementen 2 handelt es sich vorzugsweise um Vakuumfixierungen, insbesondere um Vakuumöffnungen als Teil von Vakuumkanälen. In der Substrathalterplatte sind mehrere, insbesondere mindestens zwei, Ausnehmungen 3 eingearbeitet, die bevorzugt im selben Abstand vom jeweiligen Rand 1s des Substrathalters 1 angeordnet sind. Bei den Ausnehmungen 3 handelt es sich vorzugsweise um durchgehende Bohrungen, die in dieser Ausführungsform kreisförmig ausgebildet sind. Die Ausnehmungen 3 können aber jede beliebige Form, insbesondere eine rechteckige Form haben. Auch Ausnehmungen 3 mit kompliziert gefräster Geometrie sind möglich.

Die **Figur 4b** zeigt eine schematische Oberansicht eines zweiten erfindungsgemäßen Substrathalters 1' mit einer Substrathalterplatte, auf der, insbesondere mehrere, Fixierelemente 2` zur Fixierung eines Substrats 4 (nur teilweise dargestellt) vorhanden sind. Bei den Fixierelementen 2' handelt es sich vorzugsweise um Vakuumfixierungen, insbesondere um Vakuumöffnungen als Teil von Vakuumkanälen. In der Substrathalterplatte sind mehrere, insbesondere mindestens zwei, Ausnehmungen 3' eingearbeitet. Bei den Ausnehmungen 3' handelt es sich vorzugsweise um, von einem Rand 1s' des Substrathalters 1' ausgeführte, ins Innere führende, längliche Ausnehmungen 3`, die insbesondere durch einen Fräsvorgang erzeugt wurden. Durch die erfindungsgemäße Ausgestaltung der Ausnehmungen 3' ist vorteilhaft ein Überheben des Substrathalters 1' über die unteren Optiken 7ul, 7ur nicht notwendig.

Die genannten Substrathalter 1, 1' können an der Unter- und/oder Oberseite einer erfindungsgemäßen Anlage verwendet werden.

Die **Figur 5a** zeigt ein Flussdiagramm des ersten erfindungsgemäßen Verfahrens. Die Prozessschritte 100 bis 103 werden nur einmal ausgeführt, während die Prozessschritte 104 bis 106 insgesamt n-mal ausgeführt werden können. Der Prozessschritt 107 wurde der Anschaulichkeit halber in einer eigenen Figur 2h dargestellt und ist dem Prozessschritt 104 äquivalent, mit dem Unterschied, dass hier bereits ein drittes Substrat 40' auf einen bereits erzeugten Substratstapel 9 verbondet werden.

Die **Figur 5b** zeigt ein Flussdiagramm des zweiten erfindungsgemäßen Verfahrens. Die Prozessschritte 200 bis 203 werden nur einmal ausgeführt, während die Prozessschritte 204 bis 206 insgesamt n-mal ausgeführt werden können. Der Prozessschritt 207 wurde der Anschaulichkeit halber in einer eigenen Figur 3h dargestellt und ist dem Prozessschritt 204 äquivalent, mit dem Unterschied, dass hier bereits ein drittes Substrat 4o' auf einen bereits erzeugten Substratstapel 9" verbondet werden.

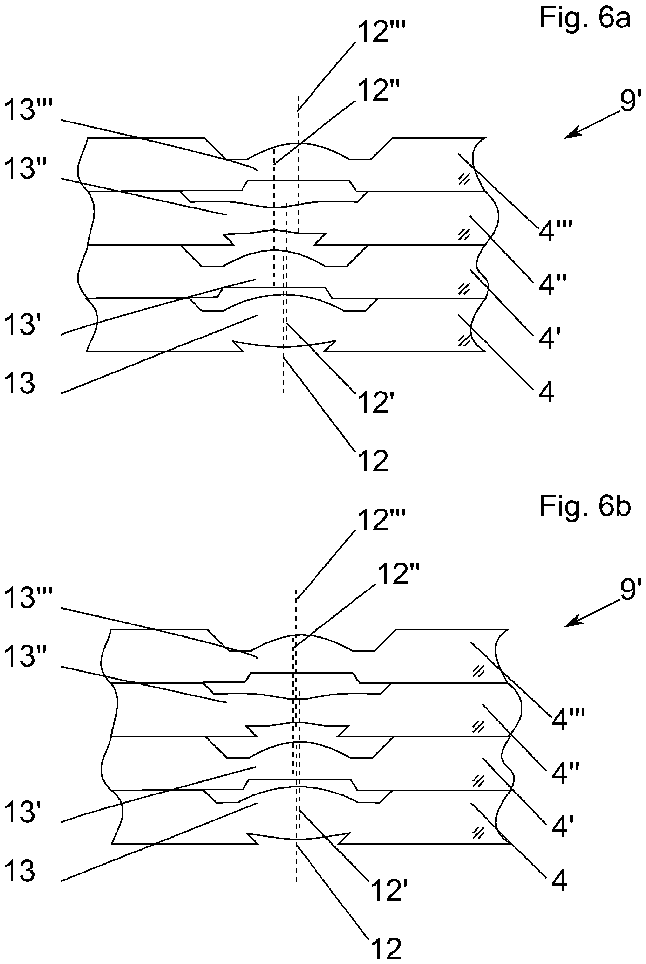

Die **Figur 6a** zeigt den Stand der Technik und zwar einen Teilausschnitt eines Substratstapels 9', bestehend aus vier, mit zunehmenden Ausrichtungsfehlern behafteten, übereinander gestapelten Substraten 4,4',4",4‴. Bei den Substraten 4, 4', 4", 4‴ handelt es sich exemplarisch um monolithische Linsenwafer. Optische Achsen 12,12',12",12‴ von optischen Elementen 13,13',13",13‴, insbesondere Linsen, sind nicht kollinear. Erkennbar ist vor allem, dass der Abstand zwischen zwei optischen Achsen zweier aufeinanderfolgender optischer Elemente 13,13',13",13‴ steigt.

Die **Figur 6b** zeigt einen Teilausschnitt eines Substratstapels 9', hergestellt mit dem erfindungsgemäßen Verfahren, bestehend aus vier, mit gleichbleibenden Ausrichtungsfehlern behafteten, übereinander gestapelten Substraten 4,4',4",4‴, Bei den Substraten 4, 4', 4", 4‴ handelt es sich exemplarisch um monolithische Linsenwafer. Die optischen Achsen 12 der optischen Elemente 13,13',13",13‴ insbesondere Linsen, sind nicht kollinear. Erkennbar ist aber, dass der Abstand zwischen den optischen Achsen des n-ten Substrat 4', 4", 4‴ und des ersten Substrats 4 annähernd gleich ist, da das n-te Substrat 4',4",4‴ erfindungsgemäß zum ersten Substrat 4 ausgerichtet wird. Ein optimaler Zustand wäre eine Stapelung und Ausrichtung der Substrate 4,4',4",4‴ derart, sodass die optischen Achsen 12,12',12",12‴ aller optischen Elemente 13,13',13",13‴ kollinear sind.

### Bezugszeichenliste

- 1,1',1u, 1o: Substrathalter
- 1s,1s': Rand
- 2, 2': Fixierungen
- 3, 3': Ausnehmungen
- 4o,4o',4u,4,4',4",4‴: Substrat
- 5ul,5ur,5ol,5or,5ul',5ur': Ausrichtungsmarken
- 6ul,6ur,6ol,6or: Sichtbereich
- 7ul, 7ur, 7ol, 7or: Optik
- 8l, 8r: Erfassungseinheit
- 9,9',9",9‴: Substratstapel
- 10ul,10ol,10ur,10or: Optische Achsen
- 12,12',12",12‴: Optische Achse
- 13, 13', 13"13‴: Optisches Element
- t: Schärfentiefebereich

## Patentansprüche

1. Verfahren zum Bonden von mindestens drei Substraten (4o,4u,4,4'4",4‴,4o') zu einem Substratstapel (9,9',9"), wobei der Substratstapel (9,9',9") mindestens ein unterstes Substrat (4u,4), ein mittleres Substrat (4o,4') und ein oberes Substrat (4o',4") aufweist, mit den folgenden Schritten:
- Ausrichtung des mittleren Substrats (4o,4') zum untersten Substrat (4u,4) und Bonden des mittleren Substrats (4o,4') mit dem untersten Substrat (4u,4),
- danach Ausrichtung des oberen Substrats (4o',4") und Bonden des oberen Substrats (4o',4") mit dem mittleren Substrat (4o,4'), **dadurch gekennzeichnet, dass** das obere Substrat (4o',4") zum untersten Substrat (4u,4) ausgerichtet wird.

2. Verfahren nach Anspruch 1 wobei jedes Substrat (4o,4u,4,4',4",4‴,4o') eine Vielzahl an optischen Linsen (13, 13',13", 13‴) ausweist.

3. Verfahren nach einem der vorhergehenden Ansprüche, wobei das obere Substrat (4o',4") zu Ausrichtungsmarken (5ul,5ur,5ul',5ur') des untersten Substrats (4u,4) ausgerichtet wird.

4. Verfahren nach einem der vorhergehenden Ansprüche, wobei jedes nachfolgende Substrat (4‴) zum untersten Substrat (4u,4) ausgerichtet wird.

5. Verfahren nach Anspruch 2, wobei optische Achsen (12,12',12",12‴) der übereinander angeordneten Linsen (13, 13',13",13‴) deckungsgleich ausgerichtet sind.

6. Verfahren nach einem der vorhergehenden Ansprüche, wobei mindestens vier Substrate (4o,4u,4,4',4",4"',4o') miteinander gebondet werden, bevorzugt mindestens fünf Substrate (4o,4u,4,4',4",4‴,4o'), weiter bevorzugt mindestens 10 Substrate (4o,4u,4,4',4",4‴,4o'), noch weiter bevorzugt mindestens 15 Substrate (4o,4u,4,4',4",4‴,4o').

7. Verfahren nach einem der vorhergehenden Ansprüche, mit dem folgenden Ablauf:
- Anordnen und Fixieren des untersten Substrats (4u,4) auf einem unteren Substrathalter (1u,1,1'),
- Erfassen von Ausrichtungsmarken (5ul,5ur,5ul',5ur') auf dem untersten Substrat (4u,4) in Sichtbereichen (6ul,6ur,6ol,6or) von Optiken (7ul,7ur,7ol,7or),
- Anordnen und Fixieren des mittleren Substrats (4o,4') auf einem oberen Substrathalter (lo,1,1'),
- Erfassung von Ausrichtungsmarken (5ul,5ur,5ul',5ur') auf dem untersten Substrat (4u,4) mittels der Optiken (7ul,7ur,7ol,7or),
- Ausrichten des mittleren Substrats (4o,4') zum untersten Substrat (4u,4),
- Bonden des mittleren Substrats (4o,4') mit dem untersten Substrat (4u,4), wobei die gebondeten Substrate (4o,4',4u,4) auf dem unteren Substrathalter (1u,1,1') verbleiben,
- Anordnen und Fixieren des oberen Substrats (4o',4") auf dem oberen Substrathalter (1o,1,1'),
- Erfassung von Ausrichtungsmarken auf dem oberen Substrat mittels der Optiken (7ul,7ur,7ol,7or),
- Ausrichten des oberen Substrats (4o',4") zum untersten Substrat (4u,4),
- Bonden des oberen Substrats (4o',4") mit dem mittleren Substrat (4o,4') zur Herstellung des Substratstapels (9`).

8. Verfahren nach Anspruch 7, wobei die Erfassung der Ausrichtungsmarken (5ul,5ur,5ul',5ur') durch unter dem untersten Substrat (4u,4) angeordnete Optiken (7ul,7ur) durch Ausnehmungen (3,3') im unteren Substrathalter (1u,1,1 ') erfolgt.

9. Verfahren nach Anspruch 8, wobei die Ausnehmungen (3, 3') als durchgängige Bohrungen im unteren Substrathalter (1u, 1,1') ausgebildet sind.

10. Verfahren nach Anspruch 8, wobei die Ausnehmungen (3, 3') als Langlöcher im unteren Substrathalter (1u,1,1') ausgebildet sind.

11. Verfahren nach Anspruch 7, wobei der untere Substrathalter (1u,1,1') derart verfahrbar ist, dass die unteren Optiken (7ul,7ur) innerhalb von Ausnehmungen (3,3') angeordnet sind.

12. Verfahren nach einem der vorhergehenden Ansprüche, wobei der untere Substrathalter (1u,1,1') durch eine Z-Positioniereinheit derart präzise in Z-Richtung verfahren wird, dass eine Abweichung in einer X- und Y-Richtung minimal ist.

13. Verfahren nach einem der vorhergehenden Ansprüche, wobei eine Nachjustiereinheit eine Abweichung des unteren Substrathalters (1u,1,1') in X- und/oder Y-Richtung bei einer Bewegung in Z-Richtung korrigiert.

14. Ausrichtungsanlage aufweisend einen ersten Substrathalter (1u,1,1') und einen zweiten Substrathalter (1o) sowie Optiken (7ul,7ur) für ein Verfahren nach einem der vorhergehenden Ansprüche, wobei der erste Substrathalter (1u, 1, 1') Ausnehmungen (3, 3') zur Aufnahme der Optiken (7ul,7ur) und Fixierelemente (2,2'), vorzugsweise Vakuumöffnungen, zur Fixierung eines Substrats (4u,4) aufweist.

## Claims

1. A method for the bonding of at least three substrates (4o, 4u, 4, 4', 4", 4"', 4o') to form a substrate stack (9, 9', 9"), wherein the substrate stack (9, 9', 9") comprises at least a lowest substrate (4u, 4), a middle substrate (4o, 4') and an upper substrate (4o', 4"), with the following steps:
- alignment of the middle substrate (4o, 4') with the lowest substrate (4u, 4) and bonding of the middle substrate (4o, 4') to the lowest substrate (4u, 4),
- then alignment of the upper substrate (4o', 4") and the bonding of the upper substrate (4o', 4") with the middle substrate (4o, 4'), **characterised in that** the upper substrate (4o', 4") is aligned with the lowest substrate (4u, 4).

2. The method according to claim 1, wherein each substrate (4o, 4u, 4, 4', 4", 4‴, 4o') comprises a plurality of optical lenses (13, 13', 13", 13‴).

3. The method according to any one of the preceding claims, wherein the upper substrate (4o', 4") is aligned with alignment marks (5ul, 5ur, 5ul', 5ur') of the lowest substrate (4u, 4).

4. The method according to any one of the preceding claims, wherein each following substrate (4‴) is aligned with the lowest substrate (4u, 4).

5. The method according to claim 2, wherein optical axes (12, 12', 12", 12‴) of the lenses (13, 13', 13", 13‴) arranged above one another and are aligned congruent.

6. The method according to any one of the preceding claims, wherein at least four substrates (4o, 4u, 4, 4', 4", 4‴, 4o') are bonded together, preferably at least five substrates (4o, 4u, 4, 4', 4", 4"', 4o'), more preferably at least 10 substrates (4o, 4u, 4, 4', 4", 4‴, 4o'), still more preferably at least 15 substrates (4o, 4u, 4, 4', 4", 4'", 4o').

7. The method according to any one of the preceding claims, with the following sequence:
- arrangement and fixing of the lowest substrate (4u, 4) on a lower substrate holder (1u, 1, 1'),
- detection of alignment marks (5ul, 5ur, 5ul', 5ur') on the lowest substrate (4u, 4) in fields of vision (6ul, 6ur, 6ol, 6or) of optics (7ul, 7ur, 7ol, 7or),
- arrangement and fixing of the middle substrate (4o, 4') on an upper substrate holder (1o, 1, 1'),
- detection of alignment marks (5ul, 5ur, 5ul', 5ur') on the lowest substrate (4u, 4) by means of optics (7ul, 7ur, 7ol, 7or),
- alignment of the middle substrate (4o, 4') with the lowest substrate (4u, 4),
- bonding of the middle substrate (4o, 4') with the lowest substrate (4u, 4), wherein the bonded substrates (4o, 4', 4u, 4) remain on the lower substrate holder (1u, 1, 1'),
- arrangement and fixing of the upper substrate (4o', 4") on the upper substrate holder (1o, 1, 1'),
- detection of alignment marks on the upper substrate by means of optics (7ul, 7ur, 7ol, 7or),
- alignment of the upper substrate (4o', 4") with the lowest substrate (4u, 4),
- bonding of the upper substrate (4o', 4") with the middle substrate (4o, 4') for the production of the substrate stack (9').

8. The method according to claim 7, wherein the detection of the alignment marks (5ul, 5ur, 5ul', 5ur') by optics (7ul, 7ur) arranged beneath the lowest substrate (4u, 4) takes place by means of recesses (3, 3') in the lower substrate holder (1u, 1, 1').

9. The method according to claim 8, wherein the recesses (3, 3') are constituted as through-holes in the lower substrate holder (1u, 1, 1').

10. The method according to claim 8, wherein the recesses (3, 3') are constituted as elongated holes in the lower substrate holder (1u, 1, 1').

11. The method according to claim 7, wherein the lower substrate holder (1u, 1, 1') can be moved in such a way that the lower optics (7ul, 7ur) are arranged inside the recesses (3, 3').

12. The method according to any one of the preceding claims, wherein the lower substrate holder (1u, 1, 1') is moved precisely in the Z-direction by a Z-positioning unit, in such a way that a deviation in an X- and Y-direction is minimal.

13. The method according to any one of the preceding claims, wherein a readjustment unit corrects a deviation of the lower substrate holder (1u, 1, 1') in the X- and/or Y-direction when a movement in the Z-direction takes place.

14. An alignment system comprising a first substrate holder (1u, 1, 1') and a second substrate holder (1o) as well as optics (7ul, 7ur) for a method according to any one of the preceding claims, wherein the first substrate holder (1u, 1, 1') comprises recesses (3, 3') for receiving the optics (7ul, 7ur) and fixing elements (2, 2'), preferably vacuum openings, for the fixing of a substrate (4u, 4).

## Revendications

1. Procédé de liaison d'au moins trois substrats (4o, 4u, 4, 4', 4", 4‴, 4o') en une pile de substrats (9, 9', 9"), dans lequel la pile de substrats (9, 9', 9") présente au moins un substrat le plus en-dessous (4u, 4), un substrat médian (4o, 4') et un substrat de dessus (4o', 4"), comprenant les étapes suivantes :
- alignement du substrat médian (4o, 4') vers le substrat le plus en-dessous (4u, 4) et liaison du substrat médian (4o, 4') avec substrat le plus en-dessous (4u, 4),
- puis alignement du substrat de dessus (4o', 4") et liaison du substrat de dessus (4o', 4") avec le substrat médian (4o, 4'), **caractérisé en ce que** le substrat de dessus (4o', 4") est aligné vers le substrat le plus en-dessous (4u, 4).

2. Procédé selon la revendication 1, dans lequel chaque substrat (4o, 4u, 4, 4', 4", 4"', 4o') présente une pluralité de lentilles optiques (13, 13', 13", 13"').

3. Procédé selon l'une des revendications précédentes, dans lequel le substrat de dessus (4o', 4") est aligné par rapport à des marquages d'alignement (5ul, 5ur, 5ul', 5ur') du substrat le plus en-dessous (4u, 4).

4. Procédé selon l'une des revendications précédentes, dans lequel chaque substrat suivant (4"') est aligné vers le substrat le plus en-dessous (4u, 4).

5. Procédé selon la revendication 2, dans lequel des axes optiques (12, 12', 12", 12"') des lentilles (13, 13', 13", 13"') disposées les unes sur les autres sont alignés en coïncidence de surfaces.

6. Procédé selon l'une des revendications précédentes, dans lequel au moins quatre substrats (4o, 4u, 4, 4', 4", 4"', 4o') sont liés entre eux, de préférence au moins cinq substrats (4o, 4u, 4, 4', 4", 4‴, 4o'), plus encore de préférence au moins 10 substrats (4o, 4u, 4, 4', 4", 4"', 4o'), de manière encore plus préférée au moins 15 substrats (4o, 4u, 4, 4', 4", 4"', 4o').

7. Procédé selon l'une des revendications précédentes, comprenant le déroulement suivant :
- agencement et fixation du substrat le plus en-dessous (4u, 4) sur un support de substrat inférieur (1u, 1, 1'),
- saisie de marquages d'alignement (5ul, 5ur, 5ul', 5ur') sur le substrat le plus en-dessous (4u, 4) dans des zones visibles (6ul, 6ur, 6ol, 6or) d'optiques (7ul, 7ur, 7ol, 7or),
- alignement et fixation du substrat médian (4o, 4') sur un support de substrat supérieur (1o, 1, 1'),
- saisie de marquages d'alignement (5ul, 5ur, 5ul', 5ur') sur le substrat le plus en-dessous (4u, 4) au moyen des optiques (7ul, 7ur, 7ol, 7or),
- alignement du substrat médian (4o, 4') vers le substrat le plus en-dessous (4u, 4),
- liaison du substrat médian (4o, 4') au substrat le plus en-dessous (4u, 4), dans lequel les substrats liés (4o, 4', 4u, 4) restent sur le support de substrat inférieur (1u, 1, 1'),
- agencement et fixation du substrat de dessus (4o', 4") sur le support de substrat supérieur (1o, 1, 1'),
- saisie de marquages d'alignement sur le substrat de dessus au moyen des optiques (7ul, 7ur, 7ol, 7or),
- alignement du substrat de dessus (4o', 4") vers le substrat le plus en-dessous (4u, 4),
- liaison du substrat de dessus (4o', 4") avec le substrat médian (4o, 4') pour fabriquer la pile de substrats (9').

8. Procédé selon la revendication 7, dans lequel la détection des marquages d'alignement (5ul, 5ur, 5ul', 5ur') s'effectue par des optiques (7ul, 7ur) disposées sous le substrat le plus en-dessous (4u, 4) par des évidements (3, 3') dans le support de substrat inférieur (1u, 1, 1').

9. Procédé selon la revendication 8, dans lequel les évidements (3, 3') sont conçus en tant que perçages traversants dans le support de substrat inférieur (1u, 1, 1').

10. Procédé selon la revendication 8, dans lequel les évidements (3, 3') sont conçus en tant que trous oblongs dans le support de substrat inférieur (1u, 1, 1').

11. Procédé selon la revendication 7, dans lequel le support de substrat inférieur (1u, 1, 1') peut être ainsi déplacé que les optiques inférieures (7ul, 7ur) sont disposées à l'intérieur d'évidements (3, 3').

12. Procédé selon l'une des revendications précédentes, dans lequel le support de substrat inférieur (1u, 1, 1') est ainsi déplacé de manière précise dans le sens Z par une unité de positionnement de Z qu'un écart dans un sens X et Y est minimal.

13. Procédé selon l'une des revendications précédentes, dans lequel une unité d'ajustement ultérieur corrige un écart du support de substrat inférieur (1u, 1, 1') dans le sens X et/ou Y lors d'un mouvement dans le sens Z.

14. Installation d'alignement présentant un premier support de substrat (1u, 1, 1') et un deuxième support de substrat (1o) ainsi que des optiques (7ul, 7ur) pour un procédé selon l'une des revendications précédentes, dans lequel le premier support de substrat (1u, 1, 1') présente des évidements (3, 3') pour recevoir les optiques (7ul, 7ur) et des éléments de fixation (2, 2'), de préférence des ouvertures à vide, pour fixer un substrat (4u, 4).
